# EUROPEAN PATENT SPECIFICATION

(11) **EP 0 578 136 B1**
(45) Date of publication and mention of the grant of the patent: **22.11.1995**
(21) Application number: 93110547.2
(22) Date of filing: 01.07.1993
(51) Int. Cl.: H05K 13/00, H05K 13/08, H05K 13/04

(54) **Method for mounting components and an apparatus therefor**
Verfahren zum Montieren von Komponenten und Vorrichtung dafür
Procédé de montage de composants et appareil pour cela

(30) Priority: 01.07.1992 JP 174387/92; 07.08.1992 JP 211838/92
(43) Date of publication of application: 12.01.1994
(73) Proprietor: YAMAHA HATSUDOKI KABUSHIKI KAISHA, Iwata-shi Shizuoka-ken, 438 (JP)
(72) Inventor: Sakurai, Hiroshi, Hamamatsu-shi, Sizuoka-ken (JP); Indo, Kenichi, Hamakita-shi, Sizuoka-ken (JP); Onodera, Hitoshi, Iwata-shi, Sizuoka-ken (JP); Ohta, Hiroyuki, Hamamatsu-shi, Sizuoaka-ken (JP)
(74) Representative: Grünecker, Kinkeldey, Stockmair & Schwanhäusser Anwaltssozietät

(56) References cited:
- EP-A- 0 144 717
- IECON'90 vol. 1, 30 November 1990, PACIFIC GROVE CALIFORNIA USA,pages 798 - 804, XP000217328 ICOS VISION SYSTEMS NV 'New trends in SMD pick & place machines put high demands on vision systems'

## Description

The present invention relates to a method for mounting a component at a specific position, preferably on a substrate such as a printed circuit board, by means of attracting the component by an attracting nozzle unit from a component supply unit, transferring the component and mounting same at the desired position, wherein a plurality of components are disposed in a detection area of an optical detecting means. Moreover, the present invention relates to a mounting apparatus for such a component, preferably for performing the afore-indicated method.

From the article "New trends in SMD pick & place machines put high demands on vision systems", IECON'go, vol.1, 30 November 1990, Pacific Grove California USA, pages 798-804, a method and apparatus according to the preamble of Claims 1 and 12, respectively, are known.

For mounting minute components such as ICs, resistors, condensers, etc., exactly on their specified positions on a substrate, a mounting apparatus was already suggested which attracts a component through an attracting nozzle by vacuum detecting the attracting position of the component in view of irregularities which can prevent the component from being precisely positioned on the desired spot onto the substrate. Moreover, it has been deliberated to try to balance displacements of the attracting point of the component in different directons relative to the centre of the component in order to introduce such data into the control means for precisely positioning the component. Difficulties have arisen in as far as such measurements aiming to acquire correcting values for improving the mounting accuracy considerably increase the cycle time of the assembling process, lowering the efficiency of the mounting procedure.

However, the mounting efficiency and performance of such an apparatus is relatively low and there is a demand to further reduce the cycle times of the mounting procedure to raise the mounting performance of the system.

Accordingly, it is an object of the present invention to provide a method of the type as indicated above enabling to increase the mounting performance of an apparatus operated on the basis of said method while assuring a reliable detection of the position correcting values for each of the components.

Moreover, it is another object of the present invention to provide a mounting apparatus comprising a moveable mounting head unit which facilitates and speeds up the mounting operation, preferably adapted to perform the method according to the present invention.

In order to perform said objectives, the present invention provides a method of the type as indicated above wherein a plurality of components are disposed in a detection area of an optical detecting means emitting parallel light beams to detect the projection width of each of the components for obtaining correcting amounts regarding their mounting positions, said components being disposed in said detection area such as not to overlap each other in the direction of the parallel light beams providing interference-free projections of said components.

Preferably, said components are rotated while being subject to the light beams and that the projection width of each component is detected and processed succesively.

Accordingly, since a plurality of components is disposed simultaneously in the detecting area of the optical detecting means and is subject to parallel light beams the cycle time from attraction to the mounting of the component is shortened and the mounting efficiency is improved.

Further reductions of the cycle time can be advantageously obtained in that a plurality of components is attracted successively or simultaneously while further steps to obtain the correcting amounts for the mounting positions of said components, at least partially are performed in a timesharing procedure.

In order to perform the objective in view of the apparatus aspects of the present invention an apparatus for mounting a component at a specific position, preferably on a substrate such as a printed circuit board, which comprises a moveable mounting head unit is provided as defined in Claim 12. Thus, the mounting head unit comprises a plurality of attracting nozzles each being moveably supported so as to be rotatable about its vertical axis and to be displaceable vertically along a Z-axis independently from each other while being moveable in the directions of the X-axis and Y-axis together with the mounting head unit, said attracting nozzles being disposed along a line which extends inclined with respect to parallel light beams of an optical detecting means so that components attracted to said attracting nozzles do not overlap one another in a direction of said light parallel light beams nor do the respective projections of said components interefere on a light beam receiving portion of the optical detecting means.

In this way, by means of equipping the mounting head unit with a plurality of attracting nozzles the mounting efficiency of the apparatus can be drastically improved while simultaneously it is assured that correcting values for the mounting positions of each of the jointly attracted components are reliably detected.

According to a further embodiment of the present invention, the mounting head unit comprises a plurality of attracting heads, each slideably and rotatably supporting an attracting nozzle, respectively.

According to yet another preferred embodiment and the development of the present invention, the main control unit comprises an assigning means for assigning projection width detecting domains to a light beam receiving portion of the optical detecting means for each attracting nozzle.

The last-mentioned advantageous embodiment provides a preferred solution for the problem of reliably distinguishing and discriminating the different projections arising from the plurality of components which are simultaneously disposed in the detecting area of the optical detecting means. As detecting domains for the projection width are assigned on the light beam receiving portion of the optical detecting means according to the chip components beforehand, chip components attracted to a plurality of attracting nozzles are correctly distinguished from each other and their respective mounting positions are corrected separately.

Further preferred embodiments of the present invention are laid down in the other method and apparatus sub-claims.

In the following the present invention is explained in greater detail hereinafter by means of preferred embodiments thereof in conjunction with the accompanying drawings wherein:
Figure 1 is an apparatus for mounting a component according to a preferred embodiment of the present invention in perspective view,
Figure 2 is a front view of a mounting head unit of the apparatus of Figure 1,
Figure 3 is a plan view of the mounting head unit according to Figure 2,
Figure 4 is a plan view showing the arrangement of components in a detection area of an optical detecting means of the mounting head unit of the apparatus according to Figures 1 to 3,
Figure 5 is a block diagram showing the components and control means of the component mounting apparatus according to a first embodiment of the present invention as shown in Figure 1,
Figure 6 is a flow chart explaining a component mounting procedure according to a preferred embodiment of the present invention,
Figure 7 is a flow chart explaining the procedure for attracting the components according to a preferred embodiment of the present invention,
Figure 8 is a flow chart showing the operations of detecting the components and calculating the corresponding correcting amounts in view of their mounting positions according to a preferred embodiment of the method of the present invention,
Figure 9 is a flow chart of the mounting operation for the components according to the preferred embodiment of the method of the present invention,
Figure 10 is a partial front view of the mounting head unit showing a detecting state for a large sized component,
Figures 11a through 11c are explanatory illustrations showing the method for detecting a minimum projection width of the component according to a preferred embodiment of the method of the present invention,
Figure 12 is a graph showing the change in projection width of the component in response to the angle of rotation of the attracting nozzle to which the component is attracted,
Figure 13 is an explanatory illustration for deriving the equations of a correcting amount X_{c} for the correction of the mounting position in direction of the X-axis,
Figures 14a through 14c are illustrations showing various (normal and abnormal) attracting conditions of a component,
Figure 15 is a plan view showing a component mounting apparatus according to another embodiment of the present invention,
Figure 16 is a front view of the mounting apparatus of Figure 15,
Figure 17 is an enlarged front view of a component mounting head unit of the mounting apparatus of Figure 15,
Figure 18 is an enlarged plan view of the mounting head unit of Figure 17,
Figure 19a is an explanatory illustrations showing an example of the dispostion of attracting nozzles within a detecting area of the optical detecting means of the apparatus of Figure 15,
Figure 19b is an explanatory illustration showing a laser beam irradiating state for the attracting nozzle arrangement of Figure 19a,
Figure 20a is an explanatory illustration showing another example of disposition of the attracting nozzles within a detecting area of the optical detecting means,
Figure 20b is an explanatory illustration showing another example of disposition of the attracting nozzles within a detecting area of the optical detecting means,
Figure 20c is an explanatory illustration showing a laser beam irradiating state for the arrangement of attracting nozzles of Figure 20a,
Figures 21a,21b and 21c are explanatory illustrations showing several states of usages of attracting nozzles depending on different sizes of the chip components to be mounted,
Figure 22 is an explanatory illustration showing a laser beam irradiating state in case where chip components having different sizes are attracted to two attracting nozzles of the mounting head unit,
Figure 23 is a block diagram of the components and control means of the mounting apparatus according to said second embodiment of the present invention,
Figure 24 is a flow chart of the practical steps to be performed in the component mounting method according to another preferred embodiment of the present invention,
Figure 25 is a flow chart of the control routine for attracting a component to an attracting nozzle,
Figure 26 is a flow chart showing the routine of the operation of component recognition,
Figure 27 is a flow chart showing the routine of a mounting operation according to a preferred embodiment of the method according to the present invention,
Figure 28 is an explanatory illustration showing a rotary movement of a chip component during the recognizing operation,
Figure 29 is an illustration for describing the method for obtaining the correcting amounts for the mounting positions of the components and for deriving the equations of calculation of some of the correcting amounts,
Figure 30 is a block diagram of another example of a control means for a mounting apparatus according to yet another embodiment of the present invention, and
Figure 31 is a flow chart showing a practical procedure of the component mounting method according to yet another embodiment of the present invention.

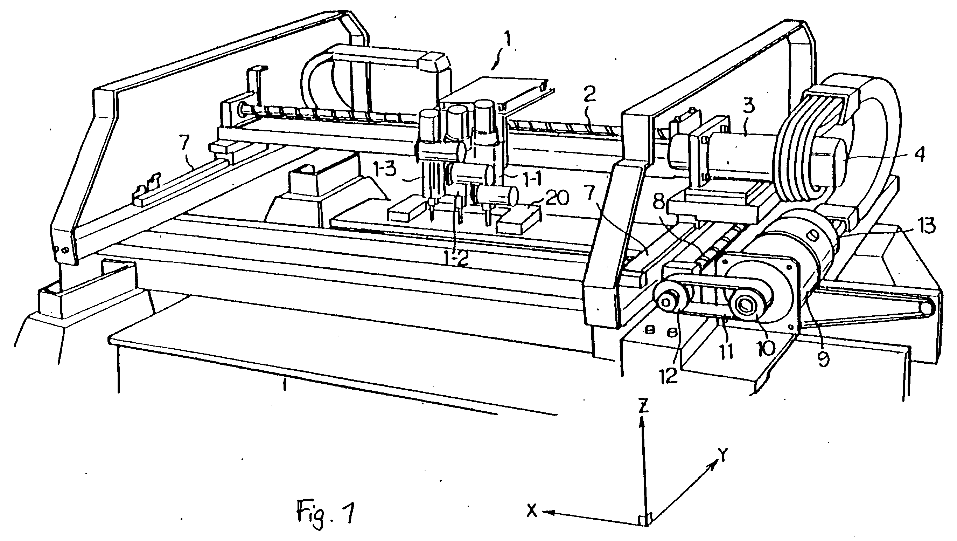

A first embodiment of this invention is described hereinafter referring to appended drawings Figures 1 to 14.

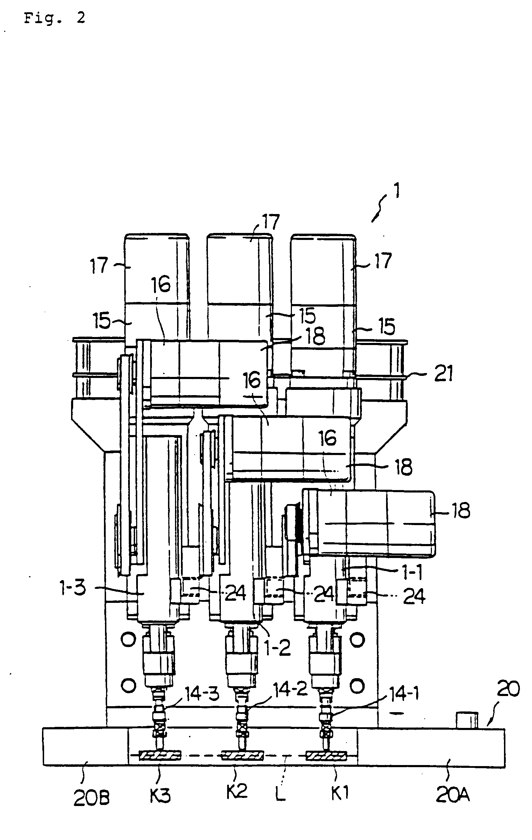

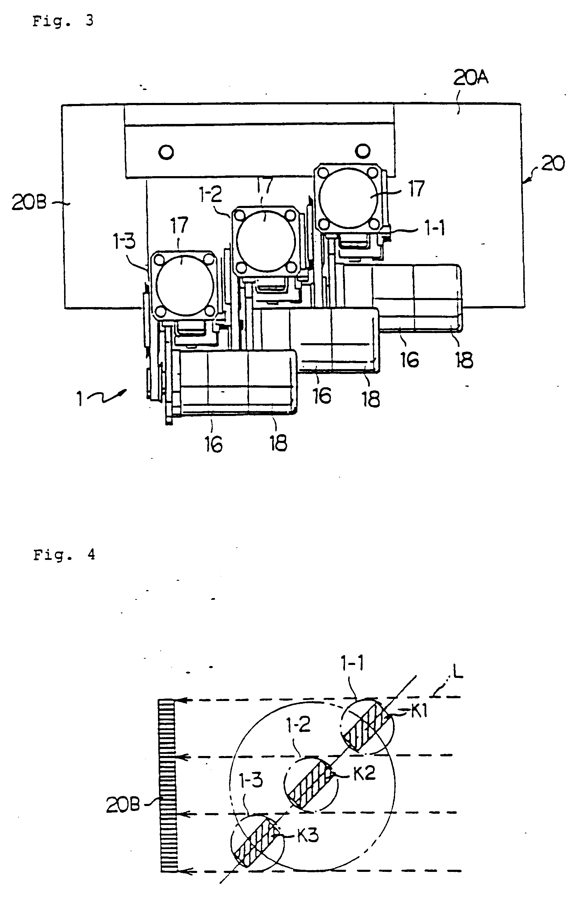

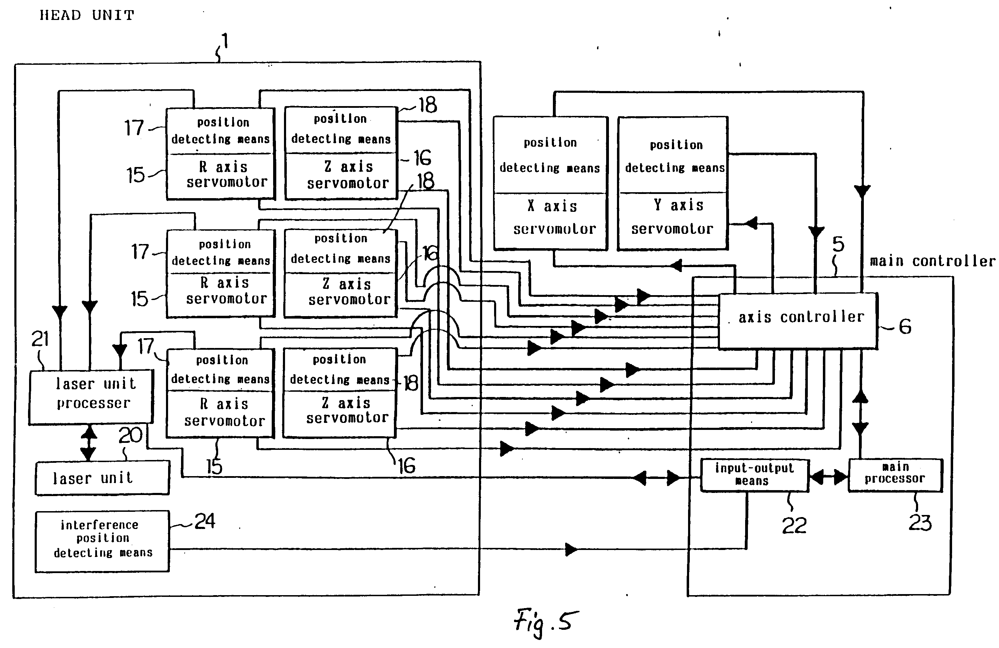

First, the basic structure of the first embodiment of the component mounting apparatus according to this invention is described referring to Figs.1 through 3. Fig.1 is a perspective view of a component mounting apparatus according to this invention, Fig.2 is a front view of a head unit equipped on the component mounting apparatus above, Fig.3 is a plan view of the head unit,Fig 4 is a plan view showing the disposition of components in the detection area, and Fig.5 is a block diagram showing the structure of the component mounting apparatus.

As shown in Fig.1, the component mounting apparatus according to this invention is provided with a head unit 1 adapted to move on the X-Y plane and having three attracting heads 1-1, 1-2 and 1-3.

The head unit 1 is in screw-engagement with a ball screw 2 rotatably disposed along the X axis so that it may be moved along the ball screw 2 in the X axis direction by rotating the ball screw 2 with an X axis servomotor 3. The X axis servomotor 3 is provided with position detecting means 4, and the servomotor 3 and the position detecting means 4 are electrically connected to the axis controller (driver) 6 of the main controller 5 as shown in Fig.5.

The ball screw 2 and the X axis servomotor 3 are supported for movement in the Y axis direction along a pair of rails 7 installed in parallel with each other, and these are in screw-engagement for movement with a ball screw 8 rotatably disposed along the Y axis. When the Y axis servomotor 9 is actuated, its rotation is transmitted to the ball screw 8 through a pulley 10, belt 11 and pulley 12 to rotate the ball screw 8, the ball screw 2, X axis servomotor 3 and head unit 1 are moved along the ball screw 8 in the Y axis direction. The Y axis servomotor 9 is provided with position detecting means 13 therefor, and the Y axis servomotor 9 and position detecting means 13 therefor are electrically connected to the axis controller (driver) 6 of the main controller 5 as shown in Fig.5.

Therefore, the head unit 1 can be moved to any desired position on the X-Y plane by rotating the ball screws 2 and 8 with the X axis servomotor 3 and the Y axis servomotor 8 as described above.

Here is described the structure of the head unit 1 referring to Figs.2 through 4.

In Fig.2, reference numerals 14-1, 14-2 and 14-3 denote attracting nozzles equipped on the attracting heads 1-1, 1-2 and 1-3, respectively, each of which is adapted to be rotated about its center axis (R axis) by an R axis servomotor 15, to be raised/lowered by a Z axis servomotor 16 in the Z axis direction, to vacuum-attract a component K1, K2 and K3,, respectively, and then to mount them at their respective specified positions. Each R axis servomotor 15 or Z axis servomotor 16 is provided with position detecting means 17 or 18, respectively, and the R axis servomotor 15 and its position detecting means 17, as well as the Z axis servomotor 16 and its position detecting means 18, are connected to the axis controller 6 of the main controller 5 as shown in Fig.5.

On the lower end of the head unit 1 is installed a laser unit 20, an optical detecting means, having a laser generator 20A and a detector (CCD) 20B disposed opposite to each other with attracting nozzles 14-1, 14-2 and 14-3 interposed therebetween. The laser unit 20 is electrically connected to a laser unit processor 21 which is connected to the main processor 23 through input-output means 22 of the main controller 5. The position detecting means 17 is connected to the laser unit 20.

Each attracting head 1-1, 1-2 and 1-3 has interference position detecting means 24 installed thereon for detecting the interference position of the component feeding device (not shown) with the attracting nozzle 14-1, 14-2 and 14-3, and the interference position detecting means 24 is connected to the input-output means 22 of the main controller 5 as shown in Fig.5.

In this embodiment, the attracting heads 1-1, 1-2 and 1-3 are arranged on a straight line extended obliquely relative to the laser beam L emitted in the X direction from the laser generator 20A of the laser unit 20 as shown in Fig.3, so that components K1, K2 and K3 attracted to these attracting heads may not overlap one another in the direction of the laser beam L within the detection area of the laser unit 20 as shown in Fig.4.

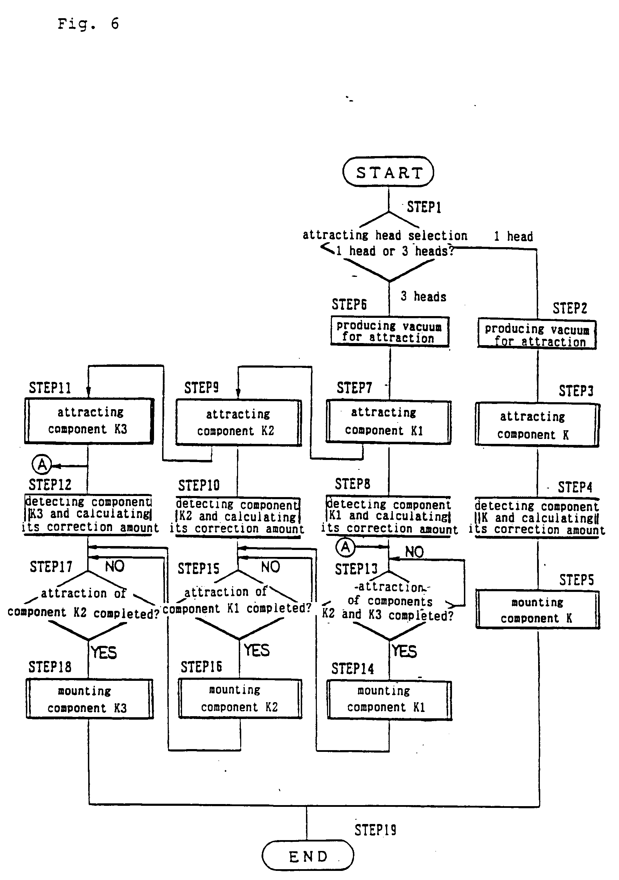

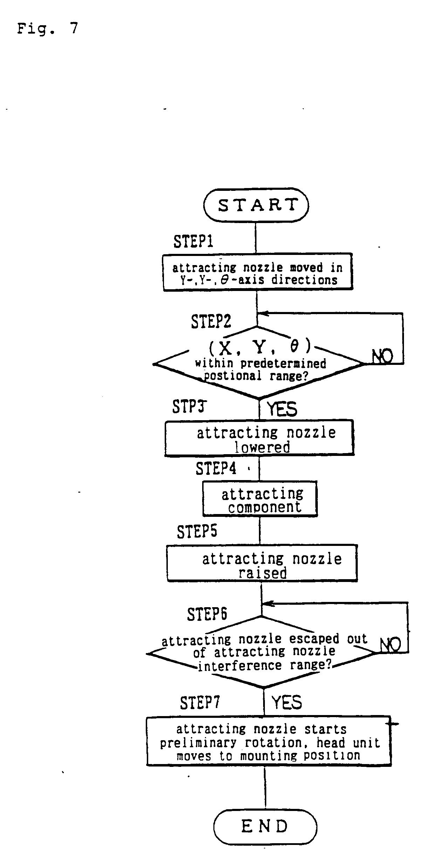

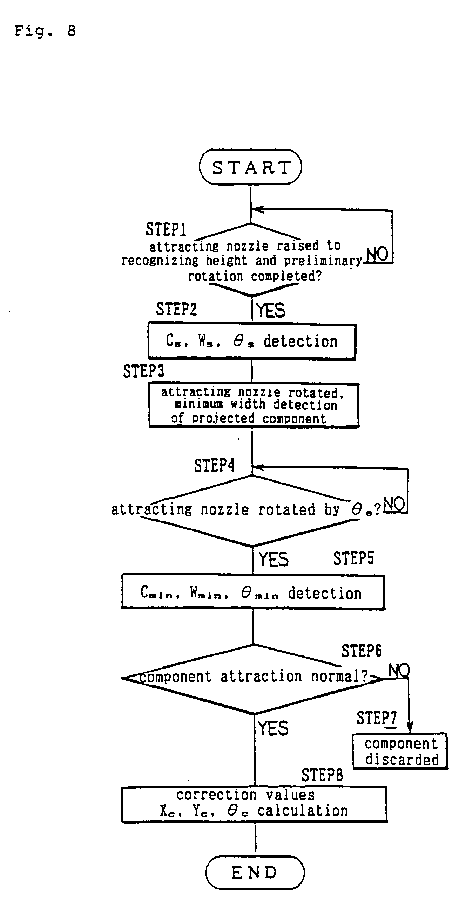

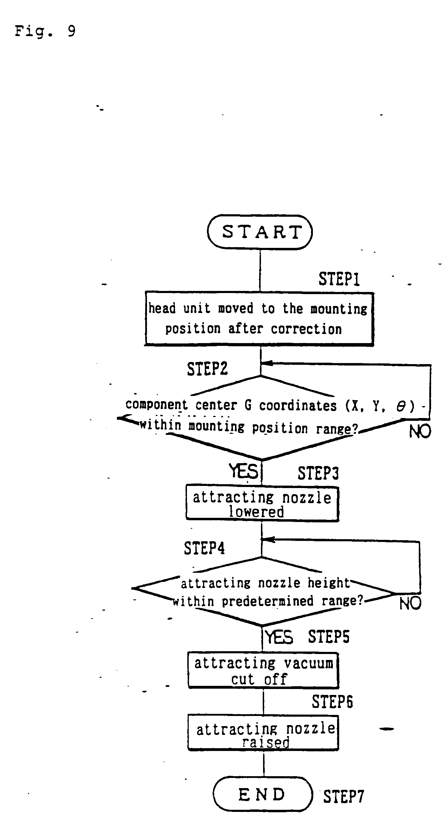

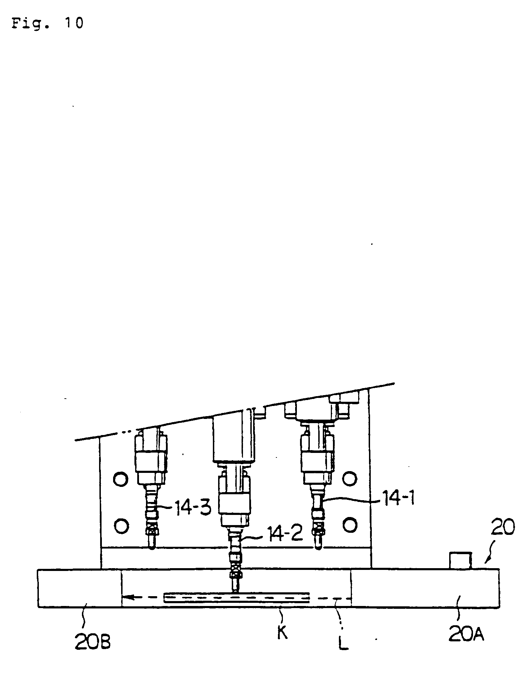

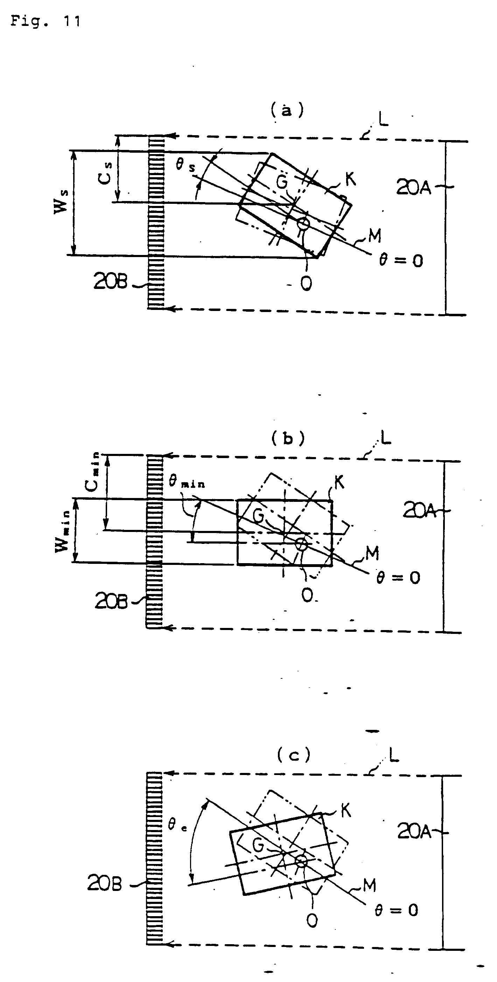

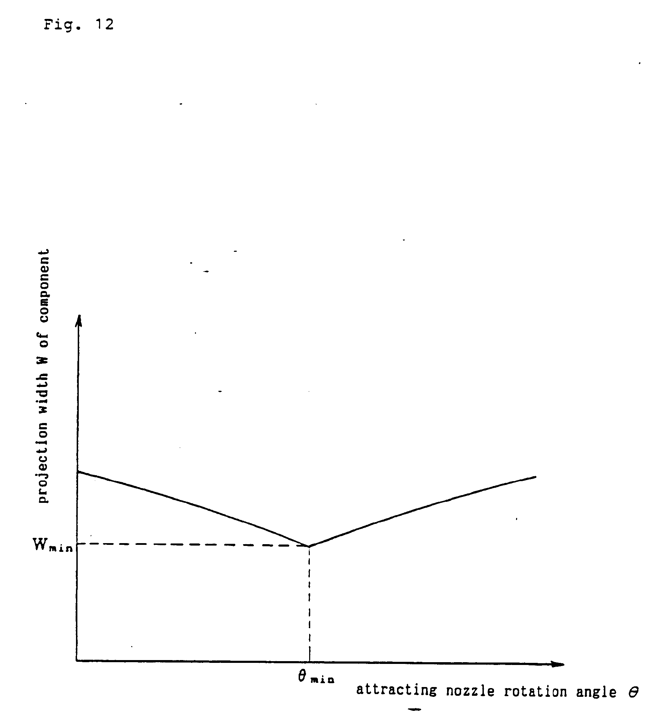

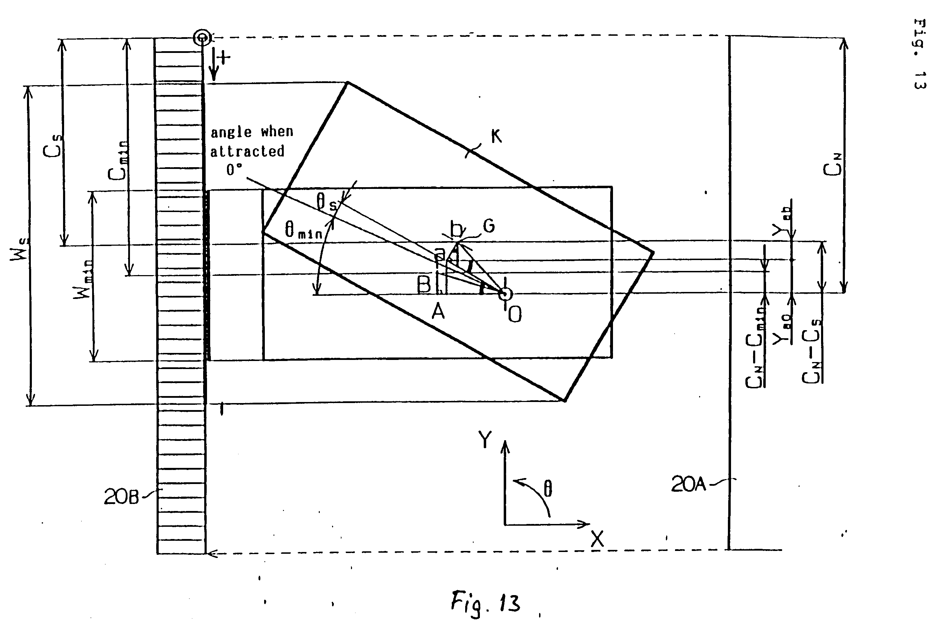

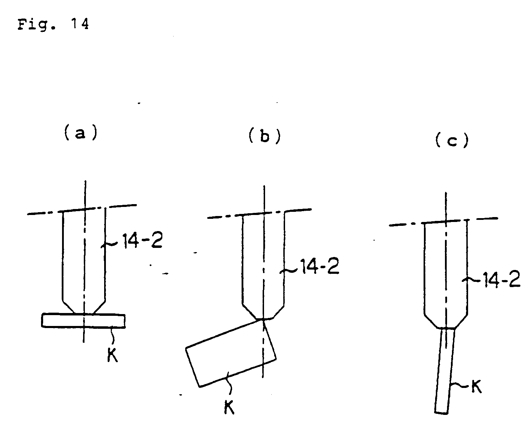

Next are described the method and procedure for mounting components with this component mounting apparatus referring to Figs.6 through 14. Fig.6 is a flow chart showing the component mounting procedure, Fig.7 is a flow chart showing the component attracting procedure, Fig.8 is a flow chart showing the operations of component detection and correction amount calculation, Fig.9 is a flow chart showing the component mounting operation, Fig. 10 is a front view showing the detecting state of a large size component, Figs.11(a) through 11(c) are explanatory illustration showing the method for detecting the minimum projection width of a component, Fig.12 is a graph showing the change of the component projection width versus the rotation angle of the attracting nozzle, Fig.13 is an explanatory illustration for deriving the equation for calculating the X direction mounting position correction amount X_{c}, and Fig.14(a) through 14(c) are illustrations showing various states of attracted components.

The component mounting apparatus according to this invention is capable of mounting three small size components K1, K2 and K3 successively by using all of three attracting heads 1-1, 1-2 and 1-3. If the feeders are installed in the same pitch as that of attracting nozzles 14-1, 14-2 and 14-3, the components K1, K2 and K3 can be attracted simultaneously. Further, it is also possible to attract one large component to the center attracting nozzle 1-2 and mount it.

To start component mounting operation, the attracting head to be used is selected first (STEP 1 in Fig.6).

When the center attracting head 1-2 is selected to mount a large size component K (See Fig.10), attracting vacuum is generated in the attracting nozzle 14-2 (STEP 2 in Fig.6), the component K is attracted by the attracting nozzle 14-2 (STEP 3 in Fig.6), the component K is detected and the mounting position correction amount for the component is caluculated by the laser unit 20 (STEP 4 in Fig.6), the component W is positioned on the basis of the mounting position correction amount obtained and mounted at its specified position (STEP 5 in Fig.6), and the component mounting operation is performed (STEP 19 in Fig.6).

On the other hand, when all of three attracting heads 1-1, 1-2 and 1-3 are selected, attracting vacuum is generated in all attracting nozzles 14-1, 14-2 and 14-3 (STEP 6 in Fig.6), a component K1 is first attracted by the attracting nozzle 14-1 (STEP 7 in Fig.6), then, while a second component K2 is being successively attracted by the attracting nozzle 14-2 (STEP 9 in Fig.6), the component K1 is detected and the mounting position correction amount therefor is calculated by the laser unit 20 (STEP 8 in Fig.6). When the detection and mounting position correction amount calculation for the component K1 are completed, operation for the component K1 is suspended until attractions of components K2 and K3 are completed (STEP 13 in Fig.6).

When the attraction of the component K2 is completed, while a third component K3 is being successively attracted by the attracting nozzle 14-3 (STEP 11 in Fig.6), the component K2 is detected and the mounting position correction amount therefor is calculated by the laser unit 20 (STEP 10 in Fig.6). When the detection and mounting position correction amount calculation for the component K2 are completed, operations for the component K2 is suspended until mounting of the component K1 is completed (STEP 15 in Fig.6).

On the other hand, when the attraction of the component K3 is completed, while the component K3 is being detected and the mounting position correction amount therefor is being calculated by the laser unit 20 (STEP 12 in Fig.6), the component K1 is mounted (STEP 14 in Fig.6), and operations for the component K3 is suspended until mounting of the component K2 is completed (STEP 17 in Fig.6). That is, since attractions of both components K2 and K3 are completed here, the decision result at the STEP 13 in Fig.6 becomes YES and the mounting operation for the component K1 is started (STEP 19 in Fig.6).

When the mounting operation for the component K1 is completed, since the decision result at the STEP 15 in Fig.6 becomes YES, the mounting operation for the component K2 is successively started (STEP 16 in Fig.6). When the mounting operation for the component K2 is completed, since the decision result at the STEP 17 in Fig.6 becomes YES, the mounting operation for the component K3 is started at last (STEP 18 in Fig.6), and a series of mounting operations for the components K1, K2 and K3 are completed here (STEP 19 in Fig.6).

Here, the practical procedures of the attracting operation (STEP 3 in Fig.6), detection and mounting position calculation (STEP 4 in Fig. 6) and mounting operation (STEP 5 in Fig.6) for the component K are described referring to Figs.7, 8 and 9, respectively. Since the procedures for the components K1, K2 and K3 are the same as those for the component K, descriptions thereabout are omitted.

When the component K is attracted, the X axis, Y axis and R axis servomotors 3, 9 and 15, respectively, are actuated, and the head unit 1 is moved to the position (component attracting position) just above the specified feeder of the component feeding device on the X-Y plane while the attracting nozzle 14-2 is rotated about the R axis (STEP 1 in Fig.7). Here, if the center coordinates (X, Y, ϑ) of the attracting nozzle is within the allowable range for the predetermined position (component attracting position) (STEP 2 in Fig.7), the Z axis servo motor 16 is actuated, the attracting nozzle 14-2 is lowered in the Z axis direction (STEP 3 in Fig.7), and the component K is attracted by the attracting nozzle 14-2 (STEP 4 in Fig.7).

When the component K is attracted by the attracting nozzle 14-2 as described above, the Z axis servo-motor 16 is again actuated and the attracting nozzle is raised along the Z axis (STEP 5 in Fig.7), and, when it is confirmed by the interference position detecting means 24 that the attracting nozzle 14-2 has escaped from the interference range with the component feeding device (STEP 6 in Fig.7), while the R axis servomotor 15 is actuated to rotate the attracting nozzle 14-2 clockwise by an angle ϑₛ (this is called "preliminary rotation"), the X axis and Y axis servomotors 3 and 9 are actuated to move the head unit 1 on the X-Y plane toward the component mounting position (STEP 7 in Fig.7). The amounts of movement of the head unit 1 (attracting nozzle 14-2) in the X and Y axis directions and the amount ϑ of rotation of the attracting nozzle 14-2 about the R axis are detected by the position detecting means 4, 13 and 17, respectively, fed back to the axis controller 6 of the main controller 5, and the axis controller 6 controls actuation of respective servomotors 3, 9 and 15 on the basis of the feed back data.

Here is described the preliminary rotation, referring to Fig.11(a).

When the component K is attracted as shown in chain lines in Fig.11(a), the attracted point of the component K (the rotation center point of the attracting nozzle 14-2) is taken as O, and a straight line M passing through the attracted point O in parellel to the longer side of the component K is taken as the rotation starting line (ϑ=0) of the attracting nozzle 14-2.

The R axis servomotor 15 is actuated as described above with the component K attracted on the attracting nozzle 14-2 to preliminarily rotate the attracting nozzle 14-2 clockwise by an angle ϑₛ, and the component K is rotated in the same sense by the same angle ϑₛ from the chain line position to the solid line position. The preliminary rotation is an operation for certainly producing the state of the component K in which the width W of the component K projected on the Y axis becomes minimum (state shown in Fig.11(b)).

Next are described the detection of the component K and the calculation of the mounting position correction amount therefor referring to Fig.8.

When it is confirmed that the attracting nozzle 14-2 reaches the recognizing height of the laser unit 20 and the preliminary rotation is completed (STEP 1 in Fig.8), the laser unit 20 starts detecting the component K (STEP 2 in Fig.8).

Here is described the method for detecting the component K by the laser unit 20 referring to Figs.11(a), 11(b) and 11(c).

If a laser beam L is emitted in parallel to the X axis from the laser generator 20A of the laser unit 20 while the component K is in a state shown in solid lines in Fig.11(a) due to the preliminary rotation, since the light intensity of the laser beam L is lower in the portion of the detector 20B corresponding to the projection width Wₛ of the component K on the detector 20B (Y axis) is lower because the laser beam L is intercepted by the component K, the projection width Wₛ of the component K on the Y axis is detected by the detector 20B. At the same time, the center position Cₛ of the projection width Wₛ of the component K and the rotation angle ϑₛ of the attracting nozzle 14-2 are also detected, and these values Wₛ, Cₛ and ϑₛ are fed to the main processor 23 of the main controller 5 through the laser unit processor 21 and the input-output means 22 of the main controller 5.

When the detections above are completed, the R axis servomotor 15 is actuated, the attracting nozzle 14 is rotated counterclockwise by a specified angle ϑₑ (e.g., 45° ), the component K is also rotated about the attracted point O from its chain line position in Fig.11(a) to its solid line position in Fig.11(c) as shown in Fig.11(c), and, during this rotation, the projection width W of the component K on the Y axis is detected by the laser unit 20 (STEP 3 and 4 in Fig.8).

If the projection width W of the component K on the Y axis is detected by the laser unit 20 while rotating the component K as described above, the projection width W first decreases gradually with the increase in the rotation angle ϑ as shown in Fig.12, and reaches its minimum in the state of the component K shown in Fig.11(b) (the state in which the longer side of the component K becomes parallel to the X axis).

In the state described above, the minimum projection width Wₘᵢₙ of the component K, the center position Cₘᵢₙ of the projection width Wₘᵢₙ, and the rotation angle ϑₘᵢₙ of the attracting nozzle 14 are detected (STEP 5 in Fig.8), and these values Wₘᵢₙ, Cₘᵢₙ and ϑₘᵢₙ are fed to the main processor 23 of the main controller 5 through the laser unit processor 21 and the input-output means 22 of the main controller 5.

Thereafter, the main processor 23 of the main controller 5 judges whether the component K is normally attracted as shown in Fig.14(a), or is attracted in an abnormal (rather upright) state as shown in Fig.14(b) or Fig.14(c) using the input data ϑₛ, ϑₑ, Wₘᵢₙ and ϑₘᵢₙ (STEP 6 in Fig.8), and, if the component K is not attracted normally, the component K is discarded (STEP 7 in Fig.8).

When it is confirmed that the component K is normally attracted, the main processor 23 of the main controller 5 calculates the component mounting position correction amounts X_{c}, Y_{c} and ϑ_{c} in the X, Y and ϑ directions (STEP 8 in Fig.4).

Among the correction amounts X_{c}, Y_{c} and ϑ_{c} above, correction amounts Y_{c} and ϑ_{c} in the Y and ϑ directions are calculated, using the following equations:${\text{Y}}_{\text{c}} {\text{= C}}_{\text{min}} {\text{- C}}_{\text{N}}$${\text{ϑ}}_{\text{c}} {\text{= ϑ}}_{\text{min}}$

In the equation (1), C_{N} is the center position (attracting point) of the attracting nozzle 14 as shown in Fig.13, and, since this is a known value, the correction amounts Y_{c} and ϑ_{c} are values obtainable substantially by actual measurement.

The X-direction correction amount X_{c} is obtained by calculations, using data Cₛ, ϑₛ, Cₘᵢₙ and ϑₘᵢₙ obtained by detections. The equation for these calculations are derived as follows referrring to Fig.13.

In Fig.13, ΔAOB ≡ ΔaOb, and, because$\overline{\text{a b}} \text{=} \overline{\text{A B}} {\text{= C}}_{\text{N}} {\text{- C}}_{\text{min}}$
the projection length Y_{ab} of the side a̅ b̅ on the Y axis is obtained from the following equation:${\text{Y}}_{\text{ab}} {\text{= (C}}_{\text{N}} {\text{- C}}_{\text{min}} {\text{) cos(ϑ}}_{\text{min}} {\text{+ ϑ}}_{\text{s}} \text{)}$

Similarly, the projection length Yₐₒ of the side a̅ o̅ on the Y axis is obtained by the following equation:${\text{Y}}_{\text{ao}} \text{=} \overline{\text{a o}} {\text{sin (ϑ}}_{\text{min}} {\text{+ ϑ}}_{\text{s}} \text{)} {\text{= (C}}_{\text{N}} {\text{- C}}_{\text{s}} {\text{) - Y}}_{\text{ab}} {\text{= (C}}_{\text{N}} {\text{- C}}_{\text{s}} {\text{) - (C}}_{\text{N}} {\text{- C}}_{\text{min}} {\text{) cos(ϑ}}_{\text{min}} {\text{+ ϑ}}_{\text{s}} \text{)}$

Therefore, the correction amount X_{c} in the X axis direction can be calculated from the equation (5) by the following equation:${\text{X}}_{\text{c}} \text{= A O = a O} \text{=} \frac{{\text{(C}}_{\text{N}} {\text{- C}}_{\text{s}} {\text{) - (C}}_{\text{N}} {\text{- C}}_{\text{min}} {\text{) cos(ϑ}}_{\text{min}} {\text{+ ϑ}}_{\text{s}} \text{)}}{{\text{sin (ϑ}}_{\text{min}} {\text{+ ϑ}}_{\text{s}} \text{)}}$

Next is described the mounting operation for the component K referring to Fig.9.

After the component mounting position correction amounts X_{c}, Y_{c} and ϑ_{c} in the X direction. Y direction and ϑ direction, respectively, are calculated as described above, the X axis, Y axis and ϑ axis servomotors 3, 9 and 15, respectively, are actuated, and the head unit 1 is moved according to the correction amounts X_{c}, Y_{c} and ϑ_{c} (STEP 1 in Fig.9). Then, when it is confirmed that the coordinates (X, Y and ϑ) of the center point G of the component K comes in the range of the predetermined mounting position (STEP 2 in Fig.9), the Z axis servomotor 16 is actuated and the mounting nozzle 14-2 is lowered together with the component K (STEP 3 in Fig.9), then, when it is confirmed that its height has come in the predetermined range (STEP 4 in Fig.9), the attracting vacuum which has been applied to the attracting nozzle 14-2 is cut off (STEP 5 in Fig.9), and the component K is mounted accurately at the specified position.

After the component K is mounted, the Z axis servomotor 16 is actuated and the attracting nozzle 14-2 is raised (STEP 6 in Fig.9), thus a series of mounting operations is performed (STEP 7 in Fig.9).

In this embodiment, since a plurality of components K1, K2 and K3 are detected as they are in the detection area of the laser unit 20 and are successively mounted at their specified positions in this embodiment, the cycle time from attraction to mounting of each component is shortened and the mounting efficiency of these components K1, K2 and K3 is improved.

Further, since the mounting position correction amounts for a component (e.g.,K1) for which detection has been completed are successively calculated in parallel while the next component (e.g., K2) is being detected, the cycle time is further shortened and a still higher mounting efficiency is obtained.

Although the embodiment described above is equipped with triple attracting heads 1-1, 1-2 and 1-3, this invention is not limited to such an apparatus but can be applied to others equipped with multiple attracting heads.

As is clear from the description above, according to this invention, since a plurality of components are detected as they are and mounted at their specified positions successively, the cycle time from attraction to mounting of a component is shortened and the component mounting efficiency is improved.

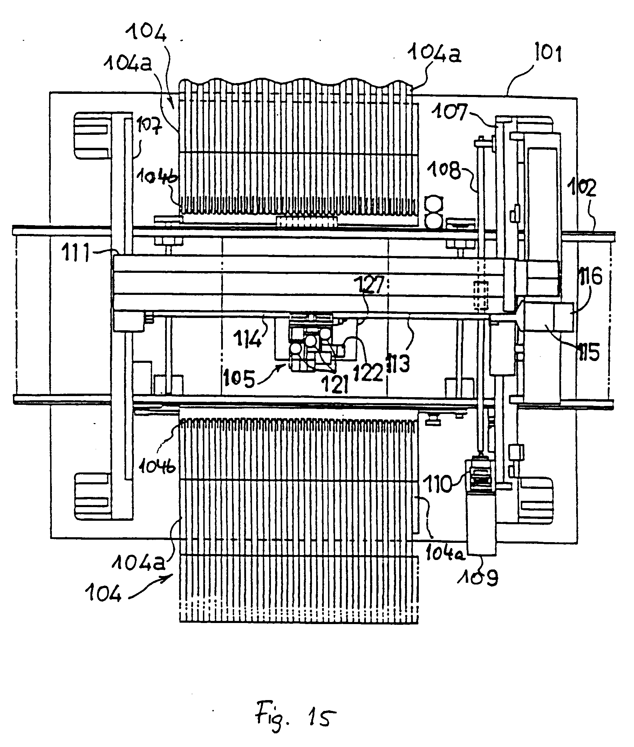

In the following further preferred embodiments of the present invention are explained with respect to Figures 15 to 31.

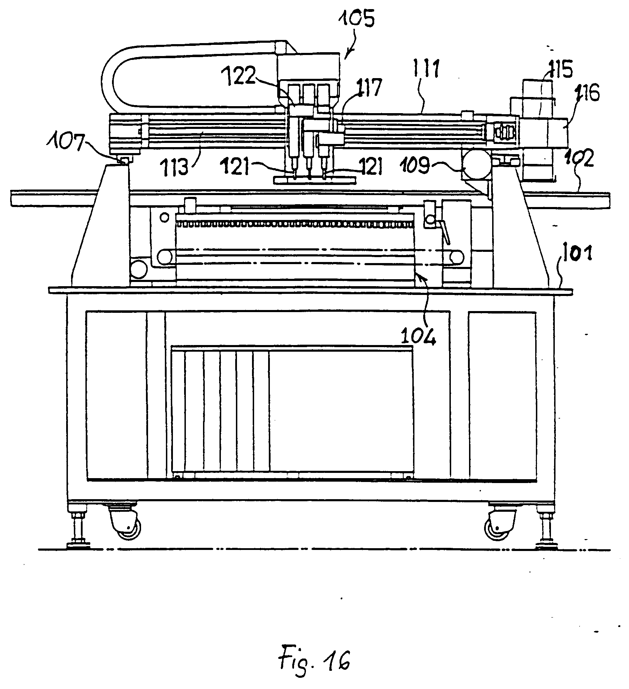

Fig.15 and Fig.16 show the overall structure of a component mounting apparatus according to another embodiment of this invention. As shown, a conveyer 102 for conveying printed substrates is installed on the base 101, the printed substrate is conveyed on the conveyer 102, and is brought to a stop at a specified position on the component mounting station.

On the sides of the conveyer 102 are disposed component feeding portions 104 each provided with many rows of feeder tapes 104a. Each feeder tape holds and contains chip components 120 such as ICs, transisters, condensers, etc., at regular intervals, and is wound around a reel. The component feeding portion 104 has a ratchet type feeder mechanism incorporated at the send-out end 104b of the feeder tape 104a, and the feeder tape 104a is intermittently sent out as chip components 120 are successively picked up form the send-out end 104b by the head unit 105, so that the pick-up operation may be repeated.

A head unit 105 adapted to move both in the X axis direction (direction of the conveyer 102) and in the Y axis direction (direction perpendiclar to the X axis direction on a horizontal plane) is installed above the base 101.

That is, while a pair of fixed rails 107 extended in the Y axis direction across the conveyer 102 are disposed on the base 101 in parallel with each other keeping a specified distance therebetween, a ball screw 108 to be rotated by a Y axis servomotor 109 is disposed near one fixed rail 107 as the feed mechanism in the Y axis direction. A support member 111 for supporting the head unit 105 is movably supported on both fixed rails 107, and the nut portion 112 of the support member 111 at one end thereof is in screw-engagement with the ball screw 108 so that the support member 111 may be moved in the Y axis direction by the rotation of the ball screw 108. The Y axis servomotor 109 is provided with Y axis position detecting means 110 constituted of an encoder.

The support member 111 is, while being provided with guide rails 113 extended in the X axis direction, equipped with a ball screw 114 disposed near the guide rails 113 and an X axis servomotor 115 for rotating the ball screw 114 as an X axis direction feed mechanism. The head unit 105 is movably supported on the guide rails 113, and the nut portion 117 provided on the head unit 105 is in screw-engagement with the ball screw 114 so that the head unit 105 may be moved in the X axis direction by the rotation of the ball screw 114. The X axis servomotor 115 is provided with X axis position detecting means 116.

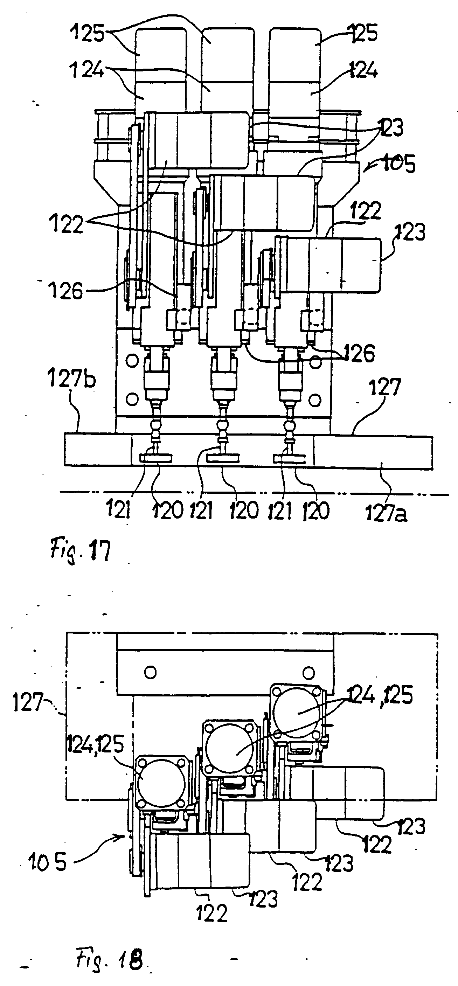

The head unit 105 is provided with a plurality of (three in this embodiment) attracting nozzles 121 for attracting chip components 120. As shown in detail in Figs.17 and 18, each attracting nozzle 121 is provided with a Z axis servomotor 122 and an R axis servomotor 124 so as to be moved in the Z axis (vertical) direction and rotated about the R axis (nozzle center axis). The servomotors 122 and 124 are provided with position detecting means 123 and 125, respectively. Further, interference position detecting means 126 for detecting the interference position of the attracting nozzle 121 with the component feeder portion 104 is installed on the head unit 105.

On the lower end portion of the head unit 105 is installed a laser unit 127 constituting the optical detecting means. The optical detecting means 127 is composed of a laser beam generating portion (parallel ray emitting portion) 127a and a detector (ray receiving portion) constituted of a CCD, and irradiates the chip component 120 in the state attracted to the attracting nozzle 121 with laser beams, parallel rays, and detects the projection width thereof.

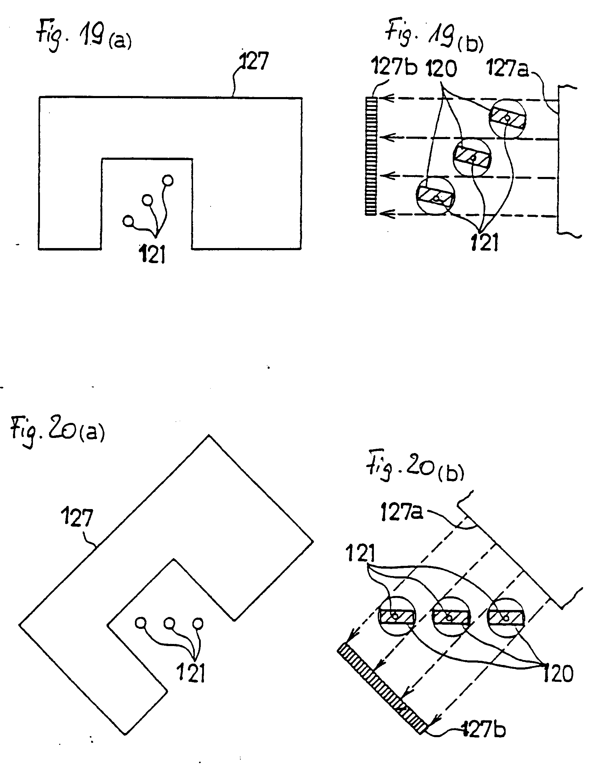

The attracting nozzles 121 and the laser unit 127 are disposed so that it may be avoided that the attracting nozzles 121 overlap one another in the direction of the laser beams. Although the laser unit 127 in the embodiment shown in Figs.15 through 18 is directed so that, as shown in Figs.19(a) and 19(b), laser beams may be emitted in the X axis direction while the attracting nozzles 121 are arranged obliquely relative to the X axis, the laser unit 127 may be directed so that laser beams may be emitted obliquely relative to the X axis while the attracting nozzles 121 are arranged in the X axis direction as shown in Figs.20(a) and 20(b). The arrangements shown in Figs.19 and 20 make the projection images of the chip components 120 attracted to the attracting nozzles 121 be formed on the different domains of the detector 127b of the laser unit 127.

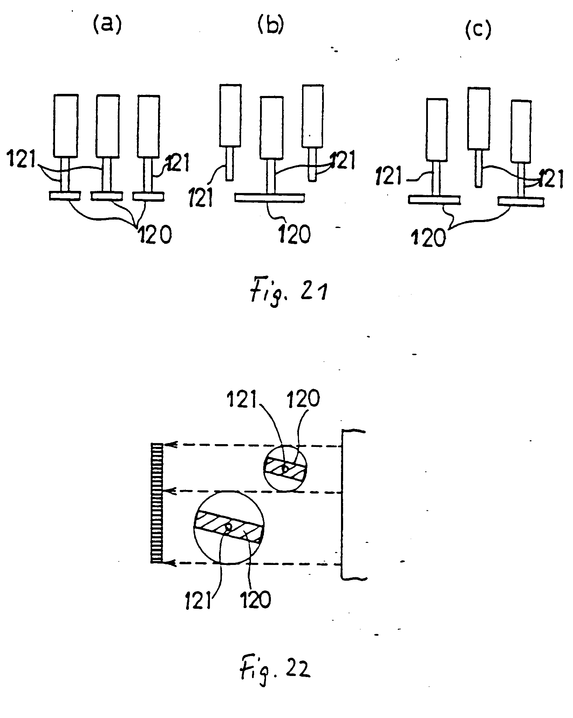

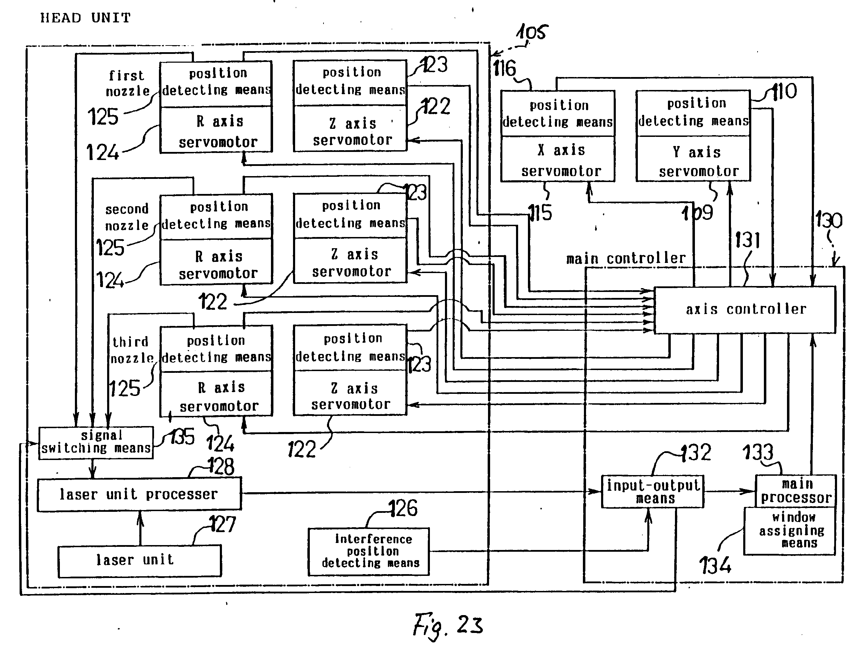

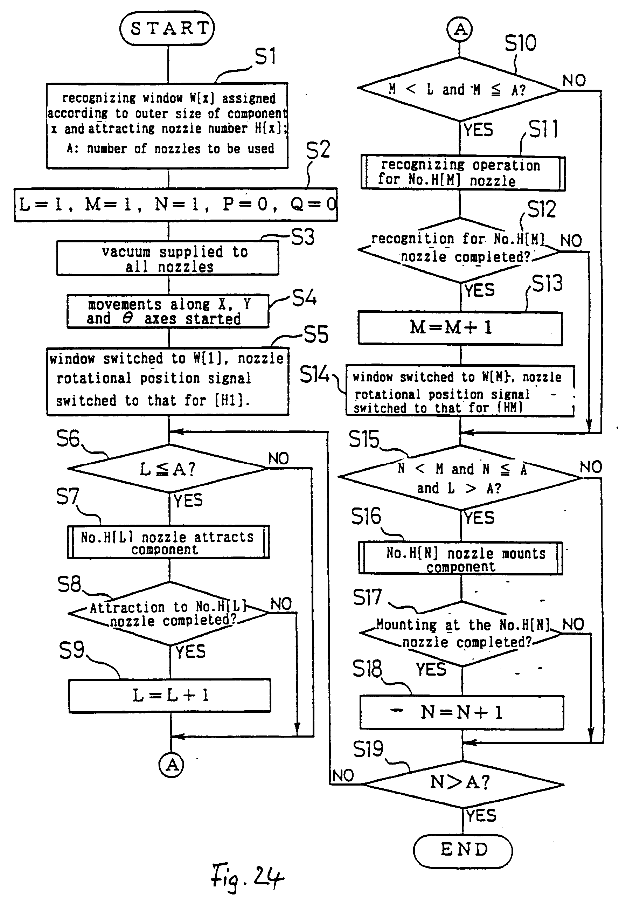

Further, although it is usual that one chip component is attracted to every attracting nozzle as shown in Fig.21(a), it is possible to attract only one chip component using only one (i.e.,the central) attracting nozzle when the chip component is large as shown in Fig. 21(b), or to attract chip components using two attracting nozzles 121, that is, it is possible to select or change the number of the attracting nozzles to be used according to the size, etc., of the chip components. Further, two or three kinds of components 120 having different sizes may be attracted at once as shown in Fig.22.

Fig.23 shows an example of the control system for the component mounting apparatus according to this embodiment, in which the X axis and Y axis servomotors 109 and 115, respectively, and Z axis and R axis servomotors 122 and 124, respectively, for respective attracting nozzles, and their position detecting means 110,116,123 and 125, respectively, are electrically connected to the axis controller (driver) 131 of the main controller 130. The laser unit 127 is electricaly connected to the laser unit processor 128 which is in turn connected to the main processor (calculating means) 133 through the input-output means 132 of the main controller 130. Further, the interference position detecting means is connected to the input-output means 132.

The main controller 130 is provided with a projection width detecting domain assigning means 134 for assigning a projection width detecting domain (to be called "window" hereinafter) for each attracting nozzle 121 according to the size of the chip component 120 and the kind of the attracting nozzle 121. The size of the chip component 120 and the kind of the attracting nozzle 121 are fed on the stage of initial setting of the mounting operation. The window assigning means 134 assigns windows appropriately by determining the number of assignments on the basis of informations to be fed, e.g., on the basis of the number of chip components 120 determined according to the size, etc., of the chip components 120 (See Fig.22), and, further, if the chip components 120 to be attracted have sizes different from one another (See Fig.23), by assigning windows so as to be fitted to each of components 120.

Further, in this embodiment, the R axis position detecting means 125 for each attracting nozzle 121 is connected to the laser unit processor 128 through signal switching means 135 so that the mounting position correction amounts of the chip components 120 attracted to the attracting nozzles 121 may be calculated successively one after another. The signal switching means 135 is adapted to switch the signal from the R axis position detecting means 125 and transmit the signal to the laser unit processor 128 according to the switching operation control signal from the main controller 130.

A practical example of the method and procedure for attracting and mounting components with an apparatus according to this embodiment is shown in Figs.24 through 27 as flow charts. The example shown in these flow charts are adapted to be applied not only to the case where the head unit 105 is equipped with three attracting nozzles but also to the case where the head unit 105 is equipped with an arbitrary plural number of attracting nozzles.

Fig.24 shows the main routine, i.e., the overall procedure of the component attracting and mounting operation. When this procedure is started, first at the step S1, a recognizing window W[x] is assigned to each chip component x (x = 1, 2,...) to be attracted to each attracting nozzle according to the outer sizes of the chip component and the attracting nozzle serial number H[x], and the number A of the attracting nozzles to be used for attracting and mounting the chip components is set. Further, at the step S2, a variable L for showing the serial number of the attracting nozzle to which a chip component was attracted, a variable M for showing the serial number of the attracting nozzle for which the recognizing operation, an operation for obtaining the component mounting position correction amount, was practiced, and a variable N for showing the serial number of the attracting nozzle for which the chip component was mounted on the printed substrate are respectively initialized to 1, while a variable P for showing the stage to which the recognizing operation has proceeded and a variable Q for showing the stage to which the mounting operation has proceeded are initialized to 0.

In succession, while vacuum is supplied to all attracting nozzles 121 at the step S3 from vacuum generating means out of drawings, movements along the X, Y and ϑ axes are started by actuating the servomotors at the step S4. At the step S5, while the window is switched to W1, the nozzle rotational position signal is switched to that for the nozzle H[1]. That is, the first window among distributed windows and a rotational position signal for the first attracting nozzle are selected.

Next, it is decided whether L ≦ A or not at the step S6. If decided yes here, it means that the number of the attracting nozzles having chip components already attracted thereto has not reached the required number A (number of attracting nozzles to be used for attracting and mounting). In this case, the routine for making the attracting nozzle (No. H[L]) attract the chip component is carried out at the step S7, then, when it is decided at the next step S8 that the attracting operation at the step S7 has been completed, the value of L is increased by an increment one at the step S9 and thus the number H[L] of the nozzle to which the component is to be attracted is changed in order, then the procedure proceeds to the step S10. When decided no at the step S6 (all of A attracting nozzles has attracted components respectively) or at the step S8 (still attracting), the procedure proceeds to the step S10 as it is.

At the step S10, it is decided whether M < L and M ≦ A. If decided yes, it means that the number of the recognized nozzles is smaller than the number of the nozzles to which components have been attracted and has not reached the required number A. In this case, a routine for carrying out the recognizing operation for the No.H[M] attracting nozzle is carried out at the step S11, then, if it is decided at the step S12 that the recognizing operation for the No.H[M] attracting nozzle has been completed, the value of M is increased by an increment one at the step S13 and thus the serial number H[M] of the nozzle to be recognized is changed in order. Further, at the step S14, while the window is switched to W[M], the nozzle rotational position signal is switched to that for the nozzle No.H[M], that is the window and the nozzle rotational position signal are changed in order in correspondence to the increase of the M value.

Then, the procedure proceeds to the step S15. If decided no at the step S10, (that is, when the number of the recognized nozzles agrees with the number of the nozzles to which components have been attracted, or when all of A nozzles have been recognized), or, if decided no at the step S12 (that is, operating for recognition), the procedure proceeds to the step S15 as it is.

At the step S15, it is decided whether N < M and N ≦ A and L > A or not. If decided yes here, it means that the number of attracting nozzles at which the components have been mounted is smaller than the number of attracting nozzles which have been recognized, and the number of the attracting nozzles at which the components have been mounted has not reached the required number A, but the number of attracting nozzles to which components have been attracted has reached the required number A. In this case, a routine for making the No.H[N] nozzle mount the component is carried out at the step S16, then, if it is decided at the step S17 that the mounting operation of the No.H[N] attracting nozzle has been completed, by increasing the value of N by an increment one at the step 18, the serial number H[N] of the nozzle at which the component is to be mounted is changed in order. Then, the procedure proceeds to the step S19. When decided no at the step S15 (the nozzles at which components have been mounted agrees with the number of the nozzles which have been recognized, or all components attracted to A attracting nozzles have been mounted, or there are nozzles to which components have not been attracted), or when decided no at the step S17 (operating for mounting), the procedure proceeds to the step S19 as it is.

At the step S19, it is decided whether N > A or not, and the procedure returns to the step S6 if dicided no, while the procedure is ended if decided yes.

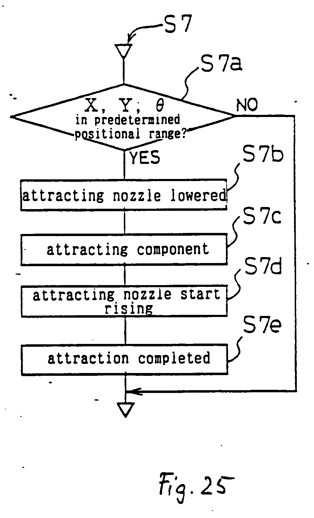

Fig.25 shows the routine of the attracting operation to be carried out at the step S7 in Fig.24. In this routine, it is investigated at the step S7a whether the center coordinates (X, Y, ϑ) of the attracting nozzle have come in the predetermined positional range for attraction. If decided not in the predetermined positional range, the procedure returns to the step S8 of the main routine shown in Fig.24, but, if decided that the center coordinates have come in the predetermined positional range, the attracting nozzle 21 is lowered at the step S7b, a chip component is attracted from the feeder tape 104a of the component feeding portion 104 at the step S7c, then the attracting nozzle 121 starts rising at the step S7d, and then, after the flag of "attraction completed" is set at the step S7e, the procedure returns to the step S8 in the main routine.

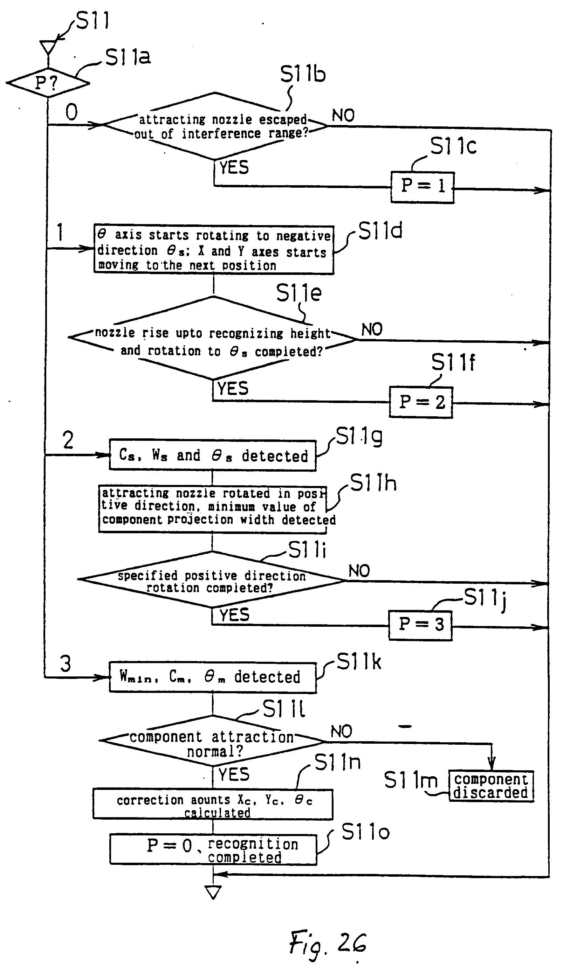

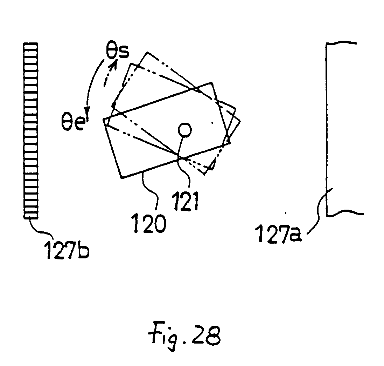

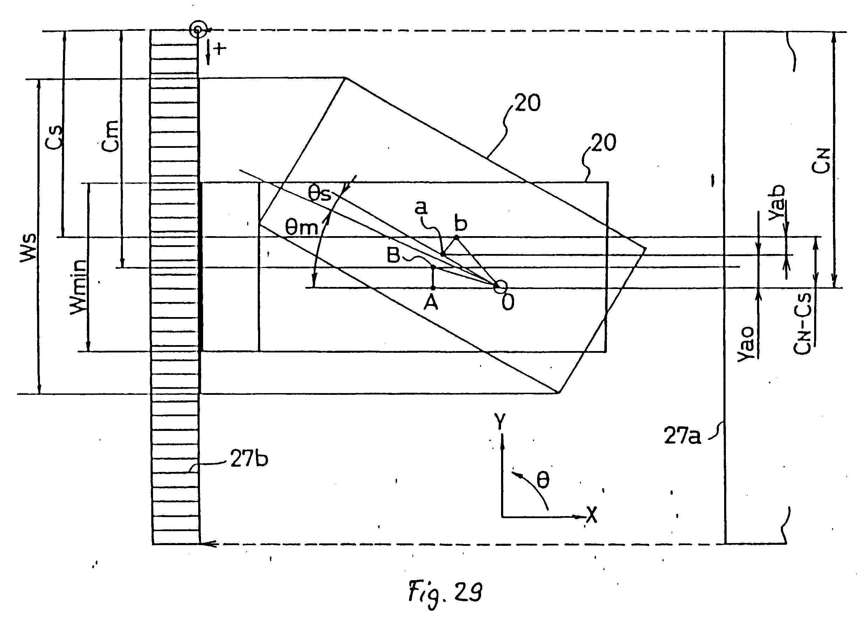

Fig.26 shows the routine for the recognizing operation carried out at the step S11. This routine is described hereafter referring also to Figs.28 and 29.

In this routine, the value of the variable P is first investigated at the step 11a. The value of the variable P shows one of stages which the recognizing operation has reached; that is, that this value is 0 means that the recognizing operation is at the stage just after attraction, that this value is 1 means that the recognizing operation is at the stage where the attracting nozzle 121 is raised to the position just escaping out of the interference range of the attracting nozzle 121 with the component feeding portion 104, that this value is 2 means that the recognizing operation is at the stage where the attracting nozzle 121 rose up to the recognizing height and the preliminary rotation was completed, and that this value is 3 means that the recognizing operation is at the stage where the specified positive direction rotation of the attracting nozzle was completed.

When P is decided "0" at the step S11a, it is decided at the step S11b whether the attracting nozzle 121 has risen up to the position where the attracting nozzle 121 escapes out of the interference range of the attracting nozzle 121 with the component feeding portion 104 or not, and, the procedure proceeds to the step S12 of the main routine as it is if decided no here, or after P is changed to "1" at the step 11c if decided yes here.

When P is decided "1" at the step S11a, the negative direction rotation of the ϑ axis by a specified angle ϑₛ (shown in Fig.28 with an arrow in dash-dot lines) is started, and the movements of the X and Y axes to the attracting position of the next attracting nozzle (when attracting operations of all of A attracting nozzles have been completed, movements to the mounting position) are started. The negative direction rotation is for securing the detection, etc., of the projection width minimum value by the subsequent positive direction rotation. Then, it is decided at the step S11e whether the attracting nozzle 21 has risen up to the height recognizable by the laser unit 127 and the negative direction preliminary rotation of the ϑ axis by a specified angle ϑₛ has been completed or not, and, and the procedure moves to the step 12 of the main routine as it is when decided no here, or after P is changed to "2" at the step S11f when decided yes here.

When P is decided "2" at the step S11a, the projection width Wₛ, center position Cₛ and rotation angle ϑₛ of the chip component at that time are detected at the step S11g, the attracting nozzle 21 is rotated in succession in the positive direction at the step S11h as shown with an arrow in solid lines in Fig.28, and the detecting operation for obtaining the minimum value of the component projection width is carried out. This positive direction rotation is carried out only by a definite angle ϑₛ. It is decided at the step S11i whether this rotation is completed or not, and the procedure proceeds to the step S12 in the main routine as it is when decided no here, or after P is changed to "3" at the step S11j when decided yes here.

When P is decided "3" at the step S11a, the projection width minimum value Wₘᵢₙ, and also the center position Cₘ and rotation angle ϑₘ corresponding to the minimum projection width are read in at the step S11k. In succession, it is decided at the step S11l whether the component attraction is normal or abnormal on the basis of the detection data, the component is discarded at the step S11m when decided abnormal, or the component mounting position correction amounts X_{c}, Y_{c} and ϑ_{c} in the X, Y and ϑ directions, respectively, are calculated on the basis of the detection data at the step 11n when decided normal. Then, after the flag of "attraction completed" is set (step S11o), the procedure proceeds to the step S12 in the main routine.

The correction amounts are calculated at the step S11n as follows: As is clearly seen in Fig.29, when the chip component 120 is to be mounted with the long side thereof extended in the X axis direction, the correction amounts Y_{c} and ϑ_{c} in the Y and ϑ directions, respectively, among the component mounting position correction amounts X_{c}, Y_{c} and ϑ_{c} are obtained from the following equations:${\text{Y}}_{\text{c}} {\text{= C}}_{\text{m}} {\text{- C}}_{\text{N}}$${\text{ϑ}}_{\text{c}} {\text{= ϑ}}_{\text{m}} \text{.}$

C_{N} is a known value representing the center position (attracting point) of the attracting nozzle 121.

Further, in Fig.29, O denotes the center point of the attracting nozzle 121, and b and B denote the chip component center points in the initial state and in the minimum projection width state, respectively, and Δ aOb ≡ Δ AOB.

When taken as follows:
- L_{AB}: : length of the segment AB,
- L_{ab}: : length of the segment ab,
- L_{AO}: : length of the segment AO,
- L_{aO}: : length of the segment aO,
- Y_{ab}: : projection length of the segment ab on the Y axis, and
- Y_{aO}: : projection length of the segment aO on the Y axis,${\text{C}}_{\text{N}} {\text{- C}}_{\text{s}} {\text{= Y}}_{\text{aO}} {\text{+ Y}}_{\text{ab}} \text{,}$${\text{Y}}_{\text{aO}} {\text{= L}}_{\text{aO}} {\text{·sin(ϑ}}_{\text{m}} {\text{+ ϑ}}_{\text{s}} \text{) and}$${\text{Y}}_{\text{ab}} {\text{= L}}_{\text{ab}} {\text{·cos(ϑ}}_{\text{m}} {\text{+ ϑ}}_{\text{s}} \text{).}$

Since L_{aO} = L_{AO} = X_{c}, and L_{ab} = L_{AB} = C_{N} - Cₘ, X_{c} is derived from the equations above as shown in the following equation:${\text{X}}_{\text{c}} {\text{= {(C}}_{\text{N}} {\text{-C}}_{\text{s}} {\text{) - (C}}_{\text{N}} {\text{- C}}_{\text{m}} {\text{)·cos(ϑ}}_{\text{m}} {\text{+ ϑ}}_{\text{s}} {\text{)}/sin(ϑ}}_{\text{m}} {\text{+ ϑ}}_{\text{s}} \text{).}$

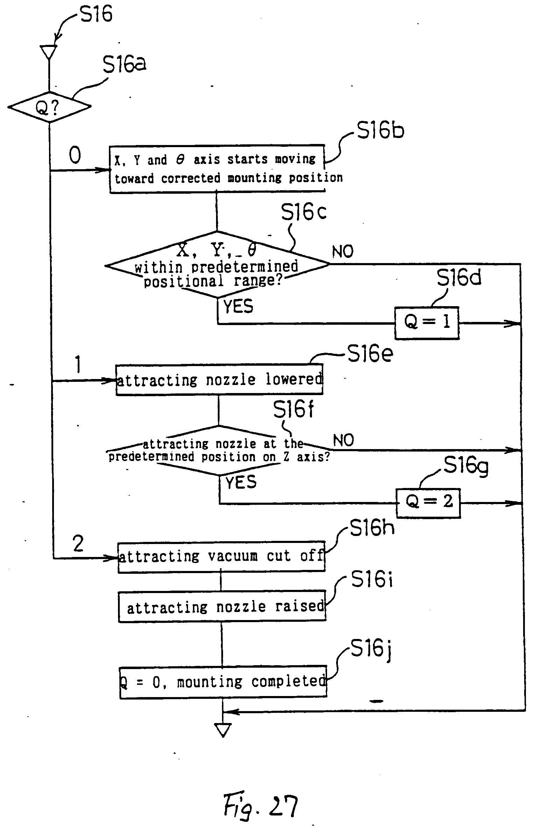

Fig.27 shows the routine of the component mouting operation to be carried out at the step S16 described above. In this routine, the value of the variable Q is first investigated at the step S16a. The value of the variable Q shows one of stages which the mounting operation has reacher; that is, that this value is "0" means that the mounting operation is at the stage just after completion of recognition, that this value is "1" means that the attracting nozzle has come in the predetermined mounting position range, and that this value is "2" means that the mounting operation is at the stage where the attracting nozzle 21 has been lowered to the predetermined position on the Z axis.

When Q is decided "0" at the step S16a, movements of the X, Y and ϑ axis toward the corrected component mounting position is started at the step S16b. At the step S16c, it is decided whether the attracting nozzle has reached the predetermined component mounting positional range or not, then the procedure proceeds to the step S17 of the main routine as it is when decided no, or after the value of Q is changed to "1" at the step S16d when decided yes.

When Q is decided "1" at the step S16a, the attracting nozzle 121 is lowered at the step S16e. Then, it is decided at the step S16f whether the attracting nozzle 121 has been lowered to the predetermined position on the Z-axis or not, then, the procedure proceeds to the step S17 of the main routine as it is when decided no, or after the value of Q has been changed to "2" at the step S16g when decided yes.

When it is decided at the step S16a that Q is "2", the component 120 is mounted on the printed substrate 102 by cutting off vacuum at the step S16h, then the attracting nozzle 121 is raised at the step S16i. After Q is reset to "0" and a flag indicative of mounting completion at the step S16g, the procedure proceeds to the step S17 of the main routine.

With the method of this embodiment described above, while chip components 120 are attracted in order to a plurality of attracting nozzles 121 installed on the head unit 105, mounting position correction amounts are obtained for the attracting nozzle 121 to which a chip component has been attracted through the recognizing operation. Since windows for recognition are distributed, windows are distinguished for each nozzle and the correction amount is obtained for each.

Even while the chip components 120 are successively attracted through the routine shown in Fig.25, recognizing operation is carried out, through the routine shown in Fig.26, for attracting nozzles which have attracted components, and the attracting operation for the attracting nozzle which has not attracted any component yet and the recognizing operation for the nozzle which has attracted a component are simultaneously advanced in parallel with each other. Further, when all of A attracting nozzles have attracted respective chip components, the head unit 105 is moved to the mounting side and the components are mounted successively through the routine shown in Fig.27 starting from one for which recognizing operation has been completed; and, the recognizing operation for the nozzle for which recognizing operation has not been completed, if any, the movement of the head unit 105 toward the mounting side and the mounting operation at the nozzle for which recognizing operation has been completed are simultaneously advanced. Thus, operations of attraction, recognition and mounting are carried out in parallel as far as possible, and the operating efficiency is improved.

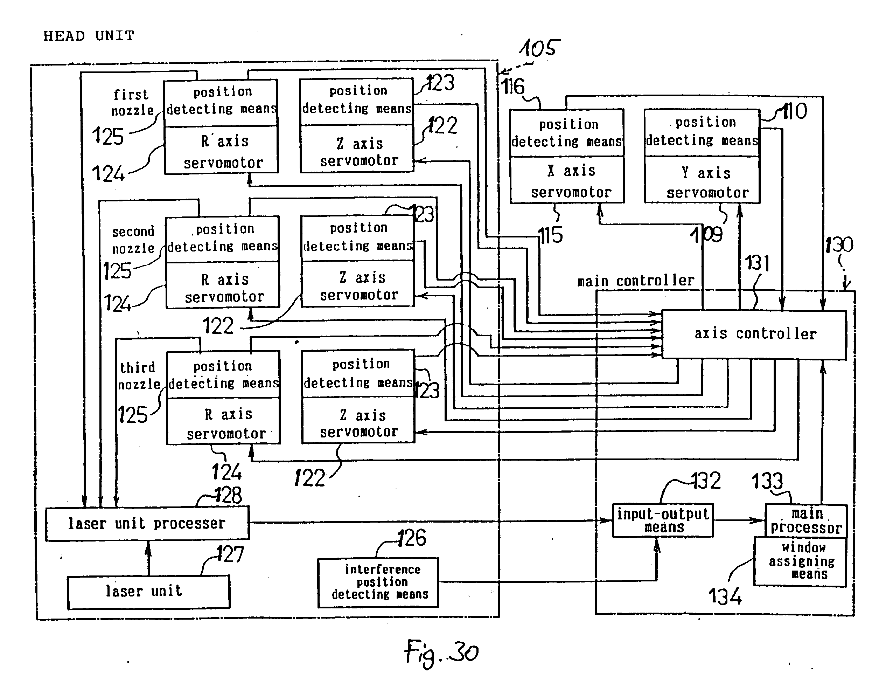

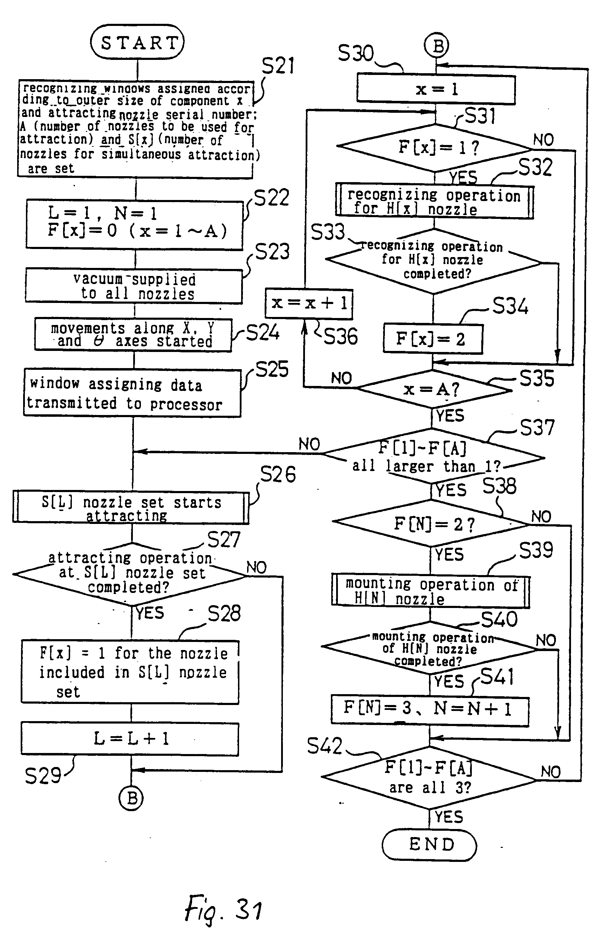

Figs.30 and 31 show other embodiments for the control system and the attracting and mounting method. This embodiment is adapted to carry out simultaneous attraction and simultaneous recognition of a plurality of chip components.

The control system shown in the block diagram of Fig.30 is different from the first embodiment shown in Fig.23 only in that the position detecting means 125 for the R axis is directly connected to the laser unit processor 128, and other features are the same as each other.

In the flow chart shown in Fig.31, first at the step S21 the recognizing window W[x] is assigned according to the outer size of the chip component x and the attracting nozzle serial number H[x], and the number A of nozzles to be used for attraction and mounting is set, while the number S[x] of attracting nozzles to be used for simultaneously attracting chip components is set. Further, at the step S22, while the registers of L and N are initialized to "1" and "1" respectively, the flag F[x] is initialized to "0". The flag F[x] shows the progressing state of operations at each nozzle, and its value "1", "2", and "3" means attracting operation completed, recognizing operation completed and mounting operation completed, respectively.

In succession, while vacuum is supplied to all attracting nozzles 21 at the step S23 from vacuum generating means out of drawings, movements along the X, Y and ϑ axes are started at the step S24. At the step S25, window assigning data W[1]~W[A] for respective attracting nozzles are transmitted to the processor.

Next, attracting operations are carried out as shown in Fig.25 simultaneously for attracting nozzles 121 included in the set including S[L] nozzles at the step S26. Further, when it is decided at the step S27 that the attracting operation of the nozzle set has been completed, while the flags F[x] for respective attracting nozzles included in the nozzle set are changed to "1", the serial number S[L] of the nozzle set to be used for attraction is successively changed by increasing the value of L one by one at the step S29, and the procedure proceeds to the step S30. When the decision at the step S27 is no, the procedure proceeds to the step S30 as it is.

Steps S30 through S36 are the procedure for recognizing operation. First, the value of x is taken as 1 at the step S30. Then, it is investigated at the step S31 whether each attracting nozzle has attracted a chip component or not by the decision whether F[x] = 1 or not while the value of x is successively changed at the steps S35 and S36 until x reaches A. If each attracting nozzle has attracted a chip component, the routine for recognizing the attracting nozzle 21 having the corresponding serial number H[x] is carried out as shown in Fig.26 at the step S32. When it is decided at the step S33 that the recognizing operation for that attracting nozzle has been completed, the corresponding flag F[x] is changed to "2", and such a procedure is repeated until x reaches A. Thus, recognizing operation is carried out starting from the attracting nozzle to which a component has been attracted, and a plurality of attracting nozzles which have simultaneously attracted chip components are simultaneously recognized.

Next, it is investigated at the step S37 whether all these attracting nozzles have at least attracted respective components or not by deciding whether all flags F[1]~F[A] respectively corresponding to A nozzles are larger than 1 or not, and the procedure returns to the step S26 when decided no here. When decided yes at the step S37, it is decided at the step S38 for the nozzle having the serial number N whether F[N] = 2 or not, namely whether it has been recognized or not. When deciding that it has been recognized, the routine for making the attracting nozzle having a serial number H[N] mount components as shown in Fig.27 is carried out. Further, when it is decided at the step S40 that the mounting operation of the H[N] attracting nozzles has been completed, while F[N] is changed to 3 at the step S41, the serial number H[N] of the nozzle for mounting the component is changed in order by increasing the value of N by an increment one, then the procedure proceeds to the step S42. When decided no at the step 38 or at the step S40, the procedure proceeds to the step S42 as it is.

It is decided at the step S42 whether all flags F[1] through A[A] have become 3 or not, and the procedure returns to the step S30 when decided no and is ended when decided yes.

By the method of this embodiment, since chip components are simultaneously mounted by a plurality of nozzles while the recognizing operation for obtaining the mounting position correction amounts for the components simultaneously attracted are also carried out simultaneously, the operating efficiency is further improved. It is similar to the case of the first embodiment that, since recognizing windows are assigned for each attracting nozzle, correction amouns are obtained separately for each nozzle.

According to this embodiment, since the head unit is provided with a plurality of attracting nozzles while projection width detecting domains for respective attracting nozzles are distributed on the ray receiving portion of the optical detecting means for detecting the projection width for mounting position correction, and the correction amounts are obtained by detecting the projection width of a chip component corresponding to the projection width detecting domain while rotating the attracting nozzle attracting the chip component, while it becomes possible to attract and mount a plurality of components with a single head unit, the mounting position can be appropriately corrected for each attracted chip component by obtaining the correction amount based on the detected projection width separately for each attracted chip component. Therefore, operations such as chip component attraction by a plurality of attracting nozzles, calculation of mounting position correction amounts and chip component mounting can be carried out efficiently and accurately.

## Claims

1. Method for mounting a component (K1,K2,K3;120) at a specific position, preferably on a substrate such as a printed circuit board, by means of attracting the component by an attracting nozzle unit (1) from a component supply unit, transferring the component and mounting same at the desired position, wherein a plurality of components (K1,K2,K3;120) are disposed in a detection area of an optical detecting means (20,127), **characterised in that,** said optical detecting means (20,127) emits parallel light beams to detect a projection width (W) of each of the components (K1,K2,K3;120) for obtaining correcting amounts (X_{c},Y_{c},ϑ_{c}) regarding their mounting positions, said components (K1,K2,K3;120) being disposed in said detection area such as not to overlap each other in the direction of the parallel light beams providing interference-free projections of said components (K1,K2,K3;120)

2. Method as claimed in claim 1, **characterised in that**, said components (K1,K2,K3:120) are rotated while being subject to the light beams, and that the projection width (W) of each component (K1,K2,K3;120) is detected and processed successively.

3. Method as claimed in claims 1 or 2, **characterised in that**, the components (K1,K2,K3;120) are successively mounted at their corrected mounting positions, respectively, after having jointly moved same from the detection area of the optical detecting means (20;127) to a mounting area of the components (K1,K2,K3;120).

4. Method as claimed in at least one of the preceding claims 1 to 3, **characterised in that**, a plurality of components (K1,K2,K3;120) is attracted successively or simultaneously while further steps to obtain correcting amounts (X_{c}, Y_{c}, ϑ_{c}) for the mounting positions of said components (K1,K2,K3;120), at least partially, are performed in a timesharing procedure.

5. Method as claimed in at least one of the preceding claims 1 to 4, **characterised in that**, each component (K1,K2,K3;120) after being attracted through the attracting nozzle (14-1,14-2,14-3;121) is preliminarily rotated by a certain angle (ϑₛ) about a vertical axis (R) of the attracting nozzle (14-1,14-2,14-3;121) while being raised by said attracting nozzle (14-1,14-2,14-3;121) in the direction of a vertical Z-axis to set the component (K1,K2,K3;120) in a predetermined starting position for further detection of a minimum projection width (Wₘᵢₙ) of the component (K1,K2,K3;120) after same has been moved into a detection area of the optical detecting means (20,127).

6. Method as claimed in claim 5, **characterised in that**, each component (K1,K2,K3;120) is rotated in the detection area of the optical detecting means (20,127) in a sense opposite to the preparatory preliminary rotation wherein the projection width (W) of the component (K1,K2,K3;120) is obtained during rotation of the component (K1,K2,K3;120) in the detection area of the optical detecting means (20,127), and in that correcting amounts (X_{c},Y_{c},ϑ_{c}) for the mounting position of the component (K1,K2,K3;120) are calculated.

7. Method as claimed in at least one of the preceding claims 1 to 6, **characterised in that**, by detecting the projection width (W) of each component (K1,K2,K3;120) rotating in a X-Y-plane through a predetermined angle of rotation (ϑₑ) about its vertical axis (R), a normal attracting position of the component (K1,K2,K3;120) is discriminated from an abnormal one and correcting amounts (Y_{c}, ϑ_{c}) for the component's mounting position with respect to the rotational position and one of the longitudinal positions of the component (K1,K2,K3;120) in direction of the X-axis or Y-axis are measured while a correcting amount (X_{c}) of the other longitudinal position is calculated on the basis of the correcting amounts (Y_{c}, ϑ_{c}) measured.

8. Method as claimed in at least one of the preceding claims 1 to 7, **characterised in that**, after attracting each component (K1,K2,K3;120) by the attracting nozzle (14-1,14-2,14-3;121) from a feeder (31) of the component supplying unit, a Z-axis servomotor (16;123) is actuated and it is investigated whether the attracting nozzle (14-1,14-2,14-3;121) has left a range of interference with the feeder and then the mounting head unit (1,105) is moved towards the component mounting position by actuating a respective servomotor (3,9, 115,108), while distances of the movement in the directions of the X-axis and Y-axis and the angle of rotation of the attracting nozzle (14-1,14-2,14-3;121) about its vertical axis (R) are detected by a position detecting means (17,18;125,123) and corresponding signals are fed back to axis controlling and driving means (6,131) of a main control unit (5,130).

9. Method as claimed in at least one of the preceding claims 1 to 8, **characterised in that** the components (K1,K2,K3;120) are subject to laser beams (L) which are emitted in parallel to one of the longitudinal axes (X or Y) of the X-Y-plane while the components are being rotated clockwise about their vertical axes (R) to detect initial start values of the projection width (Wₛ) of the components (K1,K2,K3;120), a centre position (Cₛ) of the projection width (Wₛ) and a rotational angle (ϑs) of the attracting nozzles (14-1,14-2,14-3;121), said values being fed to a main processor (23;133) of a main control unit (5;130) through a laser unit processor (21;128) and an input-output means (22;132) of the main control unit (5;130).

10. Method as claimed in at least one of the preceding claims 1 to 9, **characterised in that** each attracting nozzle (14-1,14-2,14-3;121) with the component (K1,K2,K3;120) attracted thereto is rotated counter-clockwise by a predetermined angle (ϑe) simultaneously detecting the projection width (W) of the component (K1,K2,K3;120) on one of the longitudinal axes (X-axis or Y-axis), a minimum projection width (Wₘᵢₙ) of the component (K1,K2,K3;120), the centre position (Cₘᵢₙ) of the minimum projection width (Wₘᵢₙ) and the associated minimum rotation angle (ϑₘᵢₙ) of the attracting nozzle (14-1,14-2,14-3;121) and in that the discrimination of the normal attracting position of the component (K1,K2,K3;120) from an abnormal one as well as the calculation of the non-measured correcting amount (X_{c}) for one of a longitudinal directions not measured is performed.

11. Method as claimed in at least one of the preceding claims 1 to 10, **characterised in that**, projection width detecting domains are assigned to a light beam receiving portion of the optical detecting means (127) for each attracting nozzle (14-1,14-2,14-3;121) depending on the type, specifically the size, of the component (K1,K2,K3;120) and a kind and/or required number (A) of attracting nozzles (14-1,14-2,14-3;121) to be used for attracting and mounting the component (K1,K2,K3;120) and that the position correcting amounts (X_{c},Yc,ϑ_{c}) of each component (K1,K2,K3;120) are determined corresponding to the associated projection width detecting domain while rotating the respective attracting nozzle (14-1,14-2,14-3;121) with a chip component (K1,K2,K3;120) attracted thereto.

12. Apparatus for mounting a component (K1,K2,K3;120) at a specific position, preferably on a substrate such as a printed circuit board, comprising a movable mounting head unit (1) supporting a plurality of attracting nozzles (14-1,14-2,14-3;121) disposed along a line for attracting by vacuum at least one component to be mounted, an optical component position detecting means (20,127) and a main control unit (130) for controlling the operation of the apparatus, preferably for performing the method as claimed in claim 1, **characterised in that**, each of said plurality of attracting nozzles (14-1,14-2,14-3;121) is movably supported so as to be rotatable about its vertical axis (R-axis) and to be displaceable vertically along a Z-axis independently from each other while being movable in the directions of the X-axis and Y-axis together with the mounting head unit (1,105), said attracting nozzles (14-1,14-2,14-3;121) being disposed along a line which extends inclined with respect to parallel light beams (L) of the optical detecting means (20,127) so that components (K1,K2,K3;120) attracted to said attracting nozzles (14-1,14-2,14-3;121) do not overlap one another in a direction of said parallel light beams (L) and the respective projections of said components (K1,K2,K3;120) do not interfere on a light beam receiving portion of the optical detecting means (20,127).

13. Apparatus as claimed in claim 12, **characterised in that**, the head unit (1,105) comprises a plurality of attracting heads (1-1,1-2,1-3), each slideably and rotatably supporting an attracting nozzle (14-1,14-2,14-3).

14. Apparatus as claimed in claims 12 or 13, **characterised in that**, the main control unit (130) comprises an assigning means (134) for assigning projection width detecting domains to a light beam receiving portion of the optical detecting means (127) for each attracting nozzle (121).

15. Apparatus as claimed in at least one of the preceding claims 12 to 14 , **characterised in that**, said attracting nozzle (14-1,14-2,14-3;121) is supported rotatably about its vertical centre axis (R), and in that the optical detecting means (20,127) provides a projection of the component (K,120) to detect the projection width (W) of the component (K,120) as well as to obtain mounting position correcting amounts (Y_{c}, ϑ_{c}).

16. Apparatus as claimed in at least one of the preceding claims 12 to 15, **characterised in that**, a main processor (23,133) is provided for calculating at least one mounting position correcting amount (X_{c}) of the component's mounting position in response to the other correcting amounts (Y_{c},ϑ_{c}) measured.

17. Apparatus as claimed in claims 15 or 16, **characterised in that**, the mounting head unit (1,105) is supported to be movable in a horizontal X-Y-plane.

18. Apparatus as claimed in at least one of the preceding claims 12 to 17, **characterised in that** the mounting head unit (1,105) is movable in the X-axis direction through a servomotor (3,115) having a position detecting means (4,116) associated thereto, and that the head unit (1,105) is movable in the Y-axis direction through its servomotor (9,109) having a position detecting means (13,110) associated thereto, said servomotors (3,9,115,109) and associated position detecting means (4,13,116,110) are electrically connected to an axis controlling and driving means (6,131) of the main control unit (5,130).

19. Apparatus as claimed in at least one of the preceding claims 12 to 18, **characterised in that** the attracting nozzle (14-1,14-2,14-3;121) is rotatably supported at the mounting head unit (1,105) through an R-axis servomotor (15,124) and is slideably supported to be vertically slideable along the Z-axis through a Z-axis servomotor (16,122), with respective position detecting means (17,18,125,123) being associated to the servomotors (15,16,124,122), said servomotors (15,16,124,122) and said position detecting means (17,18,125,123) being electrically connected to an axis controlling and driving means (6,131) of the main control unit (5,130).

20. Apparatus as claimed in at least one of the preceding claims 12 to 19, **characterised in that** a laser beam unit (20,127) is installed as the optical detecting means at a lower end of the mounting head unit (1,105), said laser beam unit (20,127) comprising a laser beam generator (20A,127a) and a detector (20B,127b) disposed opposite to each other on both sides of the attracting nozzle (14-1,14-2,14-3;121).

21. Apparatus as claimed in at least one of the preceding claims 12 to 20, **characterised in that** the laser beam unit (20,127) is electrically connected to a laser unit processor (21,128) which is connected to a main processor (23,13) through an input-output means (22,132) of the main control unit (5,130).

22. Apparatus as claimed in at least one of the preceding claims 12 to 20, **characterised in that** the mounting head unit (1,105) comprises an interference position detecting means (24,126) which is adapted to detect a position of interference of a component supplying unit (30) and the attracting nozzle (14-1,14-2,14-3;121) ,said interference position detecting means (24,126) being connected to an input-output means (22,132) of the main control unit (5,130).

## Patentansprüche

1. Verfahren zur Montage eines Bauteiles (K1, K2, K3; 120) an einer bestimmten Position, vorzugsweise auf einem Substrat wie einer Leiterplatte, durch Anziehen des Bauteiles durch eine Anziehungsdüseneinheit (1) von einer Bauteilversorgungseinheit, Verfahren des Bauteiles und Montieren desselben an der gewünschten Position, wobei eine Mehrzahl von Bauteilen (K1, K2, K3; 120) in einem Erfassungsbereich einer optischen Erfassungseinrichtung (20, 127) angeordnet werden, **dadurch gekennzeichnet**, daß die optische Erfassungseinrichtung (20, 127) parallele Lichtstrahlen aussendet um eine Projektionsbreite (W) jedes der Bauteile (K1, K2, K3; 120) zu erfassen, zur Erlangung von Korrekturbeträgen (X_{c}, Y_{c}, ϑ_{c}) hinsichtlich ihrer Montagepositionen, wobei die Komponenten (K1, K2, K3; 120) in dem Erfassungsbereich angeordnet werden derart, daß sie einander in der Richtung der parallelen Lichtstrahlen nicht überlappen, um störungsfreie Projektionen der Bauteile (K1, K2, K3; 120) zu schaffen.

2. Verfahren nach Anspruch 1, **dadurch gekennzeichnet,** daß die Bauteile (K1, K2, K3; 120) gedreht werden während sie den Lichtstrahlen ausgesetzt werden, und daß die Projektionsbreite (W) jedes Bauteiles (K1, K2, K3; 120) nacheinander erfaßt und verarbeitet wird.

3. Verfahren nach Anspruch 1 oder 2, **dadurch gekennzeichnet**, daß die Bauteile (K1, K2, K3; 120) nacheinander jeweils an ihren korrigierten Montagepositionen montiert werden, nachdem diese gemeinsam von dem Erfassungsbereich der optischen Erfassungseinrichtung (20; 127) zu einem Montagebereich der Bauteile (K1, K2, K3; 120) bewegt worden sind.

4. Verfahren nach zumindest einem der vorhergehenden Ansprüche 1-3, **dadurch gekennzeichnet,** daß eine Mehrzahl von Bauteilen (K1, K2, K3; 120) nacheinander oder gleichzeitig angezogen wird, während weitere Schritte zur Erlangung von Korrekturbeträgen (X_{c}, Y_{c}, ϑ_{c}) für die Montagepositionen der Bauteile (K1, K2, K3; 120) zumindest teilweise in einem Zeitteilverfahren ausgeführt werden.

5. Verfahren nach zumindest einem der vorhergehenden Ansprüche 1-4, **dadurch gekennzeichnet**, daß jedes Bauteil (K1, K2, K3; 120) nachdem es durch die Anziehungsdüse (14-1, 14-2, 14-3; 121) angezogen worden ist, vorbereitend um einen bestimmten Winkel (ϑₛ) um eine vertikale Achse (R) der Anziehungsdüse (14-1, 14-2, 14-3; 121) gedreht wird, während es durch die Anziehungsdüse (14-1, 14-2, 14-3; 121) in der Richtung einer vertikalen Z-Achse angehoben wird, um das Bauteil (K1, K2, K3; 120) in eine vorbestimmte Startposition zur weiteren Erfassung einer minimalen Projektionsbreite (Wₘᵢₙ) des Bauteiles (K1, K2, K3; 120) zu bringen, nachdem es in einen Erfassungsbereich der optischen Erfassungseinrichtung (20, 127) bewegt worden ist.

6. Verfahren nach Anspruch 5, **dadurch gekennzeichnet**, daß jedes Bauteil (K1, K2, K3; 120) in dem Erfassungsbereich der optischen Erfassungseinrichtung (20, 127) in einer Richtung entgegengesetzt zu der vorbereitenden vorläufigen Drehung gedreht wird, wobei die Projektionsbreite des Bauteiles (K1, K2, K3; 120) während der Drehung des Bauteiles (K1, K2, K3; 120) in dem Erfassungsbereich der optischen Erfassungseinrichtung (20, 127) erhalten wird, und daß Korrekturbeträge (X_{c}, Y_{c}, ϑ_{c}) für die Montageposition des Bauteiles (K1, K2, K3; 120) berechnet werden.

7. Verfahren nach zumindest einem der vorhergehenden Ansprüche 1-6, **dadurch gekennzeichnet**, daß durch Erfassen der Projektionsbreite (W) jedes Bauteiles (K1, K2, K3; 120), das sich in einer X-Y-Ebene um einen vorbestimmten Drehwinkel (ϑₑ) um seine vertikale Achse (R) dreht, eine normale Anziehungsposition des Bauteiles (K1, K2, K3; 120) von einer nicht normalen unterschieden wird und Korrekturbeträge (Y_{c}, ϑ_{c}) für die Montageposition des Bauteiles in Bezug auf die Drehposition und eine der Längspositionen des Bauteiles (K1, K2, K3; 120) in Richtung der X-Achse oder Y-Achse gemessen werden, während ein Korrekturbetrag (X_{c}) der anderen Längsposition auf der Grundlage der gemessenen Korrekturbeträge (Y_{c}, ϑ_{c}) berechnet wird.

8. Verfahren nach zumindest einem der vorhergehenden Ansprüche 1-7, **dadurch gekennzeichnet**, daß nach Anziehung jedes Bauteiles (K1, K2, K3; 120) durch die Anziehungsdüse (14-1, 14-2, 14-3; 121) von einer Zuführungsvorrichtung (31) der Bauteilversorgungseinheit, ein Z-Achsen-Servomotor (16; 123) betätigt wird, und es überprüft wird, ob die Anziehungsdüse (14-1, 14-2, 14-3; 121) einen Störungsbereich mit der Zuführungsvorrichtung verlassen hat und dann die Montagekopfeinheit (1, 105) zu der Bauteilmontageposition durch Betätigung eines jeweiligen Servomotors (3, 9, 115, 108) bewegt wird, während Bewegungswege in den Richtungen der X-Achse und der Y-Achse und der Winkel einer Drehung der Anziehungsdüse (14-1, 14-2, 14-3; 121) um ihre vertikale Achse (R) durch eine Positionserfassungseinrichtung (17, 18; 125, 123) erfaßt werden und entsprechende Signale zu einer Achsensteuer- und Achsenantriebseinrichtung (6, 131) einer Hauptsteuereinheit (5, 130) rückgespeist werden.

9. Verfahren nach zumindest einem der vorhergehenden Ansprüche 1-8, **dadurch gekennzeichnet**, daß die Bauteile (K1, K2, K3; 120) Laserstrahlen (L) ausgesetzt werden, die parallel zu einer der Längsachsen (X oder Y) der XY-Ebene ausgesendet werden, während die Bauteile im Uhrzeigersinn um ihre vertikalen Achsen (R) gedreht werden, um Anfangsstartwerte der Projektionsbreite (Wₛ) der Bauteile (K1, K2, K3; 120), eine Mittelposition (Cₛ) der Projetionsbreite (Wₛ) und einen Drehwinkel (ϑₛ) der Anziehungsdüsen (14-1, 14-2, 14-3; 121) zu erfassen, wobei die Werte zu einem Hauptprozessor (23, 133) einer Hauptsteuereinheit (5; 130) durch einen Lasereinheitprozessor (21; 128) und eine Eingabe-Ausgabe-Einrichtung (22; 132) der Hauptsteuereinheit (5; 130) zugeführt werden.

10. Verfahren nach zumindest einem der vorhergehenden Ansprüche 1-9, **dadurch gekennzeichnet**, daß jede Anziehungsdüse (14-1, 14-2, 14-3; 121) mit dem an dieser angezogenen Bauteil (K1, K2, K3; 120) im Gegenuhrzeigersinn um einen vorbestimmten Winkel (ϑₑ) gedreht wird, wobei gleichzeitig die Projektionsbreite des Bauteils (K1, K2, K3; 120) auf einer der Längsachsen (X-Achse oder Y-Achse), eine minimale Projektionsbreite (Wₘᵢₙ) des Bauteiles (K1, K2, K3; 120), die Mittelposition (Cₘᵢₙ) der minimalen Projektionsbreite (Wₘᵢₙ) und der zugeordnete minimale Drehwinkel (ϑₘᵢₙ) der Anziehungsdüse (14-1, 14-2, 14-3; 121) erfaßt werden, und daß sowohl die Unterscheidung der normalen Anziehungsposition des Bauteiles (K1, K2, K3; 120) von einer nicht normalen als auch die Berechnung eines nicht gemessenen Korrekturbetrags (X_{c}) für eine der nicht gemessenen Längsrichtungen durchgeführt wird.

11. Verfahren nach zumindest einem der vorhergehenden Ansprüche 1-10, **dadurch gekennzeichnet**, daß einem Lichtstrahl-Empfangsabschnitt der optischen Erfassungseinrichtung (127) Projektionsbreiten-Erfassungsbereiche für jede Anziehungsdüse (14-1, 14-2, 14-3; 121) zugeordnet werden, in Abhängigkeit von dem Typ, insbesondere der Größe des Bauteiles (K1, K2, K3; 120) und einer Art und/oder benötigten Anzahl (A) von Anziehungsdüsen (14-1, 14-2, 14-3; 121), die zur Anziehung und Montage des Bauteiles (K1, K2, K3; 120) zu verwenden sind, und daß die Positionskorrekturbeträge (X_{c}, Y_{c} ,ϑ_{c} ) jedes Bauteiles (K1, K2, K3; 120) entsprechend dem zugeordneten Projektionsbreiten-Erfassungsbereich bestimmt werden, während die jeweilige Anziehungsdüse (14-1, 14-2, 14-3; 121) mit einem hieran angezogen Chipbauteil (K1, K2, K3; 120) gedreht wird.

12. Vorrichtung zur Montage eines Bauteiles (K1, K2, K3; 120) an einer bestimmten Position, insbesondere auf einem Substrat wie einer Leiterplatte, mit einer beweglichen Montagekopfeinheit (1), die eine Mehrzahl von Anziehungsdüsen (14-1, 14-2, 14-3; 121) lagert, die in entlang einer Linie angeordnet sind, zur Anziehung zumindest eines zu montierenden Bauteiles durch Vakuum, einer optischen Bauteilpositions-Erfassungseinrichtung (20, 127) und einer Hauptsteuereinheit (130) zur Steuerung des Betriebs der Vorrichtung, insbesondere zur Durchführung des Verfahrens nach Anspruch 1, **dadurch gekennzeichnet**, daß jede der Mehrzahl von Anziehungsdüsen (14-1, 14-2, 14-3; 121) beweglich gelagert ist, um um ihre vertikale Achse (R-Achse) drehbar und vertikal entlang einer Z-Achse unabhängig voneinander verlagerbar zu sein, während sie in den Richtungen der X-Achse und der Y-Achse zusammen mit der Montagekopfeinheit (1, 105) beweglich sind, wobei die Anziehungsdüsen (14-1, 14-2, 14-3; 121) entlang einer Linie angeordnet sind, die relativ zu parallelen Lichtstrahlen (L) der optischen Erfassungseinrichtung (20, 127) geneigt verläuft, so daß Bauteile (K1, K2, K3; 120), die an den Anziehungsdüsen (14-1, 14-2, 14-3; 121) angezogen sind, einander in einer Richtung der parallelen Lichtstrahlen (L) nicht überlappen und sich die jeweiligen Projektionen der Bauteile (K1, K2, K3; 120) auf einen Lichtstrahl-Empfangsabschnitt der optischen Erfassungseinrichtung (20, 127) nicht gegenseitig stören.

13. Vorrichtung nach Anspruch 12, **dadurch gekennzeichnet**, daß die Kopfeinheit (1, 105) eine Mehrzahl von Anziehungsköpfen (1-1, 1-2, 1-3) aufweist, die jeweils eine Anziehungsdüse (14-1, 14-2, 14-3) gleitbar und drehbar lagern.

14. Vorrichtung nach Anspruch 12 oder 13, **dadurch gekennzeichnet**, daß die Hauptsteuereinheit (130) eine Zuordnungseinrichtung (134) zur Zuordnung von Projektionsbreiten-Erfassungsbereichen zu einem Lichtstrahlempfangsabschnitt der optischen Erfassungeinrichtung (127) für jede Anziehungsdüse (121) aufweist.

15. Vorrichtung nach zumindest einem der vorhergehenden Ansprüche 12-14, **dadurch gekennzeichnet**, daß die Anziehungsdüse (14-1, 14-2, 14-3; 127) um ihre vertikale Mittelachse (R) drehbar gelagert ist, und daß die optische Erfassungseinrichtung (20, 127) eine Projektion des Bauteiles (K, 120) schafft, um sowohl die Projektionsbreite (W) des Bauteiles (K, 120) zu erfassen als auch Montagepositionskorrekturbeträge (Y_{c} ,ϑ_{c}) zu erhalten.

16. Vorrichtung nach zumindest einem der vorhergehenden Ansprüche 12-15, **dadurch gekennzeichnet**, daß ein Hauptprozessor (23, 133 vorgesehen ist zur Berechnung zumindest eines Montagepositionskorrekturbetrages (X_{c}) der Montageposition des Bauteiles in Abhängigkeit von den anderen, gemessenen Korrekturbeträgen (Y_{c} ,ϑ_{c}).

17. Vorrichtung nach Anspruch 15 oder 16, **dadurch gekennzeichnet**, daß die Montagekopfeinheit (1, 105) gelagert ist, derart, um in einer horizontalen X-Y-Ebene beweglich zu sein.

18. Vorrichtung nach zumindest einem der vorhergehenden Ansprüche 12-17, **dadurch gekennzeichnet**, daß die Montagekopfeinheit (1, 105) in der X-Achsen-Richtung durch einen Servomotor (3, 115) beweglich ist, der eine diesem zugeordnete Positions-Erfassungseinrichtung (4, 116) aufweist, und daß die Kopfeinheit (1, 105) in der Y-Achsen-Richtung durch ihren Servomotor (9, 109) beweglich ist, der eine diesem zugeordnete Positions-Erfassungseinrichtung (13, 110) aufweist, wobei die Servomotoren (3, 9, 115, 109) und die zugeordneten Positions-Erfassungseinrichtungen (4, 13, 116, 110) elektrisch mit einer Achsensteuer- und Achsenantriebseinrichtung (6, 131) der Hauptsteuereinheit (5, 130) verbunden sind.

19. Vorrichtung nach zumindest einem der vorhergehenden Ansprüche 12-18, **dadurch gekennzeichnet**, daß die Anziehungsdüse (14-1, 14-2, 14-3; 121) an der Montagekopfeinheit (1, 105) durch einen R-Achsen-Servomotor (15, 124) drehbar gelagert ist und durch einen Z-Achsen-Servomotor (14, 122) gleitbar gelagert ist, um vertikal entlang der Z-Achse verschieblich zu sein, wobei jeweilige Positionserfassungseinrichtungen (17, 18, 125, 123) den Servomotoren (15, 16, 124, 122) zugeordnet sind, wobei die Servomotoren (15, 16, 124, 122) und die Positionserfassungseinrichtungen (17, 18, 125, 123) elektrisch mit einer Achsensteuer- und Achsenantriebseinrichtung (6, 131) der Hauptsteuereinheit (5, 130) verbunden sind.

20. Vorrichtung nach zumindest einem der vorhergehenden Ansprüche 12-19, **dadurch gekennzeichnet**, daß eine Laserstrahleinheit (20, 127) als die optische Erfassungseinrichtung an einem unteren Ende der Montagekopfeinheit (1, 105) angebracht ist, wobei die Laserstrahleinheit (20, 127) einen Laserstrahlgenerator (20A, 127a) und eine Erfassungsvorrichtung (20B, 127b) aufweist, die einander gegenüberliegend, auf beiden Seiten der Anziehungsdüse (14-1, 14-2, 14-3; 121) angeordnet sind.

21. Vorrichtung nach zumindest einem der vorhergehenden Ansprüche 12-20, **dadurch gekennzeichnet,** daß die Laserstrahleinheit (20, 127) elektrisch mit einem Lasereinheitprozessor (21, 128) verbunden ist, der mit einem Hauptprozessor (23, 13) durch eine Eingabe-Ausgabe-Einrichtung (22, 132) der Hauptsteuereinheit (5, 130) verbunden ist.

22. Vorrichtung nach zumindest einem der vorhergehenden Ansprüche 12-20, **dadurch gekennzeichnet**, daß die Montagekopfeinheit (1, 105) eine Störpositions-Erfassungseinrichtung (24, 126) aufweist, die vorgesehen ist, eine Position gegenseitiger Störung einer Bauteilversorgungseinheit (30) und der Anziehungsdüse (14-1, 14-2, 14-3; 121) zu erfassen, wobei die Störpositions-Erfassungseinrichtung (24, 126) mit einer Eingabe-Ausgabe-Einrichtung (22, 132) der Hauptsteuereinheit (5, 130) verbunden ist.

## Revendications

1. Procédé de montage de composants (K1, K2, K3; 120) à une position spécifique, de préférence sur un substrat tel qu'une carte de circuits imprimés, consistant à attirer un composant par une unité de buse d'attraction (1) à partir d'une unité d'approvisionnement de composants, à transférer le composant et à monter celui-ci à la position désirée, dans lequel une pluralité de composants (K1, K2, K3; 120) sont placés dans une zone de détection d'un ensemble de moyens de détection optique (20, 127), caractérisé en ce que lesdits moyens de détection optique (20, 127) émettent des faisceaux lumineux parallèles pour détecter une largeur de projection (W) de chacun des composants (K1, K2, K3; 120) afin d'obtenir des valeurs de correction (X_{c}, Y_{c}, ϑ_{c}) concernant leur position de montage, lesdits composants (K1, K2, K3; 120) étant disposés dans ladite zone de détection de façon à ne pas se chevaucher les uns les autres dans la direction des faisceaux lumineux parallèles produisant ainsi des projections sans interférence desdits composants (K1, K2, K3; 120).

2. Procédé selon la revendication 1, caractérisé en ce que lesdits composants (K1, K2, K3; 120) sont tournés pendant qu'ils sont sujets aux faisceaux lumineux et en ce que la largeur de projection (W) de chaque composant (K1, K2, K3; 120) est successivement détectée et traitée.

3. Procédé selon la revendication 1 ou 2, caractérisé en ce que les composants (K1, K2, K3; 120) sont successivement montés à leur position de montage corrigée respective, après que ceux-ci aient bougé conjointement de la zone de détection des moyens de détection optique (20; 127) vers une zone de montage des composants (K1, K2, K3; 120).

4. Procédé selon au moins une des précédentes revendications 1 à 3, caractérisé en ce qu'une pluralité de composants (K1, K2, K3; 120) est attirée successivement ou simultanément, tandis que d'autres étapes destinées à obtenir des valeurs de correction (X_{c}, Y_{c}, ϑ_{c}) pour les positions de montage desdits composants (K1, K2, K3; 120), sont au moins partiellement réalisées selon une procédure en temps partagé.

5. Procédé selon au moins une des précédentes revendications 1 à 4, caractérisé en ce que chaque composant (K1, K2, K3; 120), après avoir été attiré au travers de la buse d'attraction (14-2, 14-3; 121), est d'abord tourné sur un certain angle (ϑₛ) autour d'un axe vertical (R) de la buse d'attraction (14-1, 14-2, 14-3; 121) tout en étant soulevé par ladite buse d'attraction (14-1, 14-2, 14-3; 121) dans la direction d'un axe vertical Z de manière à placer le composant (K1, K2, K3; 120) dans une position de départ prédéterminée pour une nouvelle détection d'une largeur de projection minimale (Wₘᵢₙ) du composant (K1, K2, K3; 120) après que celui-ci ait été déplacé dans une zone de détection des moyens de détection optique (20, 127).

6. Procédé selon la revendication 5, caractérisé en ce que chaque composant (K1, K2, K3; 120) est tourné dans la zone de détection des moyens de détection optique (20, 127) dans un sens contraire à celui de la rotation préliminaire préparatoire durant laquelle la largeur de projection (W) du composant (K1, K2, K3; 120) est obtenue pendant la rotation du composant (K1, K2, K3; 120) dans la zone de détection des moyens de détection optique (20, 127), et en ce que des valeurs de correction (X_{c}, Y_{c}, ϑ_{c}) pour la position de montage du composant (K1, K2, K3; 120) sont calculées.

7. Procédé selon au moins une des précédentes revendications 1 à 6, caractérisé en ce que, en détectant la largeur de projection (W) de chaque composant (K1, K2, K3; 120) tournant dans un plan X-Y sur un angle de rotation prédéterminé (ϑₑ) autour de son axe vertical (R), une position d'attraction, normale pour le composant (K1, K2, K3; 120) est discernée d'une position anormale et les valeurs de correction (Y_{c}, ϑ_{c}) pour la position de montage du composant en fonction de la position de rotation et de l'une des positions longitudinales du composant (K1, K2, K3; 120) en direction de l'axe X ou de l'axe Y sont mesurées tandis qu'une valeur de correction (X_{c}) de l'autre position longitudinale est calculée sur la base des valeurs de correction mesurées (Y_{c}, ϑ_{c}).

8. Procédé selon au moins une des précédentes revendications 1 à 7, caractérisé en ce que, après que chaque composant (K1, K2, K3; 120) ait été attiré par la buse d'attraction (14-2, 14-3; 121) à partir d'un distributeur (31) de l'unité d'approvisionnement de composants, un servomoteur (16; 123) d'axe Z est actionné et il est examiné pour savoir si la buse d'attraction (14-1, 14-2, 14-3; 121) a laissé une plage d'interférence avec le distributeur, puis l'unité de tête de montage (1, 105) est déplacée vers la position de montage du composant par activation d'un servomoteur respectif (3, 9, 115, 108), tandis que des distances du mouvement dans les directions de l'axe X et de l'axe Y et l'angle de rotation de la buse d'attraction (14-1, 14-2, 14-3; 121) autour de son axe vertical (R) sont détectées par des moyens de détection de position (17, 18; 125, 133) et des signaux correspondants sont renvoyés vers les moyens de contrôle et d'entraînement des axes (6, 131) de l'unité principale de commande (5, 130).

9. Procédé selon au moins une des précédentes revendications 1 à 8, caractérisé en ce que les composants (K1, K2, K3; 120) sont sujets à des faisceaux laser (L) qui sont émis parallèlement à un des axes longitudinaux (X ou Y) du plan X-Y tandis que les composants sont tournés dans le sens des aiguilles d'une montre autour de leurs axes verticaux (R) afin de détecter les valeurs de départ initiales de la largeur de projection (Wₛ) des composants (K1, K2, K3; 120), une position centrale (Cₛ) de la largeur de projection (Wₛ) et un angle de rotation (ϑₛ) des buses d'attraction (14-1, 14-2, 14-3; 121), lesdites valeurs étant envoyées à un processeur principal (23; 133) d'une unité principale de commande (5; 130) par l'intermédiaire d'un processeur d'unité laser (21; 128) et des moyens d'entrées/sorties (22; 132) de l'unité principale de commande (5; 130).

10. Procédé selon au moins une des précédentes revendications 1 à 9, caractérisé en ce que chaque buse d'attraction (14-1, 14-2, 14-3; 121) est tournée, avec le composant (K1, K2, K3; 120) qu'elle attire, dans le sens inverse de celui des aiguilles d'une montre sur un angle prédéterminé (ϑₑ) en détectant simultanément la largeur de projection (W) du composant (K1, K2, K3; 120) sur un des axes longitudinaux (axe X ou axe Y), une largeur de projection minimale (Wₘᵢₙ) du composant (K1, K2, K3; 120), la position centrale (Cₘᵢₙ) de la largeur de projection minimale (Wₘᵢₙ) et l'angle de rotation minimale associée (ϑₘᵢₙ) de la buse d'attraction (14-1, 14-2, 14-3; 120) et en ce que la distinction de la position d'attraction normale du composant (K1, K2, K3; 120) d'une position anormale ainsi que le calcul d'une valeur de correction non mesurée (X_{c}) pour une des directions longitudinales non mesurées sont effectués.

11. Procédé selon au moins une des précédentes revendications 1 à 10, caractérisé en ce que les domaines de détection de la largeur de projection sont attribués à une portion réceptrice de faisceaux lumineux des moyens de détection optique (127) pour chaque buse d'attraction (14-1, 14-2, 14-3; 121) en fonction du type, et plus particulièrement de la taille, du composant (K1, K2, K3; 120), et du modèle et/ou du nombre requis (A) de buses d'attraction (14-1, 14-2, 14-3; 121) à utiliser pour attirer et monter le composant (K1, K2, K3; 120) et en ce que les valeurs de correction de la position (X_{c}, Y_{c}, ϑ_{c}) de chaque composant (K1, K2, K3; 120) sont déterminées en correspondance avec le domaine de détection de la largeur de projection associée tout en faisant tourner la buse d'attraction respective (14-1, 14-2, 14-3; 120) en même temps que le composant électronique (K1, K2, K3; 120) qu'elle attire.

12. Dispositif de montage de composants (K1, K2, K3; 120) à une position spécifique, de préférence sur un substrat tel qu'une carte de circuits imprimés, comprenant une unité de tête de montage mobile (1) supportant une pluralité de buses d'attraction (14-1, 14-2, 14-3; 121) disposées en ligne pour attirer par aspiration au moins un composant à monter, des moyens de détection optique de la position du composant (20, 127) et une unité principale de commande (130) pour contrôler le fonctionnement du dispositif, de préférence pour mettre en oeuvre le procédé selon la revendication 1, caractérisé en ce que chacune de ladite pluralité des buses d'attraction (14-1, 14-2, 14-3; 121) est supportée de façon mobile pour pouvoir être tournée autour de son axe vertical (axe R) et être déplacée verticalement le long d'un axe Z indépendamment les unes des autres tout en étant mobiles dans les directions de l'axe X et de l'axe Y en même temps que l'unité de tête de montage (1, 105), lesdites buses d'attraction (14-1, 14-2, 14-3; 121) étant disposées en une ligne qui s'étend de façon inclinée par rapport aux faisceaux lumineux parallèles (L) des moyens de détection optique (20, 127) pour que les composants (K1, K2, K3; 120) attirés vers lesdites buses d'attraction (14-1, 14-2, 14-3; 121) ne se chevauchent pas les uns les autres dans une direction desdits faisceaux lumineux parallèles (L) et les projections respectives desdits composants (K1, K2, K3; 120) n'interfèrent pas sur une portion réceptrice de faisceaux lumineux des moyens de détection optique (20, 127).

13. Appareil selon la revendication 12, caractérisé en ce que l'unité de tête (1, 105) comprend une pluralité de têtes d'attraction (1-1, 1-2, 1-3), chacune supportant une buse d'attraction (14-1, 14-2, 14-3) de façon coulissante et pivotante.

14. Appareil selon les revendications 12 ou 13, caractérisé en ce que l'unité principale de commande (130) comprend des moyens d'attribution (134) pour attribuer des domaines de détection de la largeur de projection à une portion réceptrice de faisceaux lumineux des moyens de détection optique (127), pour chaque buse d'attraction (121).

15. Dispositif selon au moins une des précédentes revendications 12 à 14, caractérisé en ce que ladite buse d'attraction (14-1, 14-2, 14-3; 121) est supportée de façon pivotante autour de son axe central vertical (R) et en ce que les moyens de détection optique (20, 127) produisent une projection du composant (K, 120) pour détecter la largeur de projection (W) du composant (K, 120) aussi bien que pour obtenir des valeurs de correction de la position de montage (Y_{c}, ϑ_{c}).

16. Dispositif selon au moins une des précédentes revendications 12 à 15, caractérisé en ce qu'un processeur principal (23, 133) est prévu pour calculer au moins une valeur de correction de position de montage (X_{c}) de la position de montage du composant en réponse aux autres valeurs de correction mesurées (Y_{c}, ϑ_{c}).

17. Dispositif selon les revendications 15 ou 16, caractérisé en ce que l'unité de tête de montage (1, 105) est supporté de façon à pouvoir être déplacée dans un plan horizontal X-Y.

18. Dispositif selon au moins une des précédentes revendications 12 à 17, caractérisé en ce que l'unité de tête de montage (1, 105) peut être déplacée dans la direction de l'axe X par l'intermédiaire d'un servomoteur (3, 115) ayant des moyens de détection de position (4, 116) qui lui sont associés, et en ce que l'unité de tête (1, 105) peut être déplacée dans la direction de l'axe Y par l'intermédiaire de son servomoteur (9, 109) ayant des moyens de détection de position (13, 110) qui lui sont associés, lesdits servomoteurs (3, 9, 115, 109) et moyens de détection de position (4, 13, 116, 110) associés étant électriquement connectés à des moyens de contrôle et d'entraînement des axes (6, 131) de l'unité principale de commande (5, 130).

19. Dispositif selon au moins une des précédentes revendications 12 à 18, caractérisé en ce que la buse d'attraction (14-1, 14-2, 14-3; 121) est supportée de manière pivotante par l'unité de tête de montage (1, 105) par l'intermédiaire d'un servomoteur d'axe R (15, 124) et est supportée de manière coulissante pour pouvoir coulisser verticalement le long de l'axe Z par l'intermédiaire d'un servomoteur d'axe Z (16, 122), des moyens de détection de position respectifs (17, 18, 125, 123) étant associés aux servomoteurs (15, 16, 124, 122), lesdits servomoteurs (15, 16, 124, 122) et lesdits moyens de détection de position (17, 18, 125, 123) étant électriquement connectés à des moyens de contrôle et d'entraînement des axes (6, 131) de l'unité principale de commande (5, 130).

20. Dispositif selon au moins une des précédentes revendications 12 à 19, caractérisé en ce qu'une unité de faisceaux laser (20, 127) est installée, à titre de moyens de détection optique, à une extrémité inférieure de l'unité de tête de montage (1, 105), ladite unité de faisceaux laser (20, 127) comprenant un générateur de faisceaux laser (20A, 127a) et un détecteur (20B, 127b) disposés l'un face à l'autre de part et d'autre de la buse d'attraction (14-1, 14-2, 14-3; 121).

21. Dispositif selon au moins une des précédentes revendications 12 à 20, caractérisé en ce que l'unité de faisceaux laser (20, 127) est électriquement connectée à un processeur d'unité laser (21, 128) qui est connecté à un processeur principal (23, 13) par des moyens d'entrées/sorties (22, 132) de l'unité principale de commande (5, 130).

22. Dispositif selon au moins une des précédentes revendications 12 à 20, caractérisé en ce que l'unité de tête de montage (1, 105) comprend des moyens de détection de position d'interférence (24, 126) qui sont adaptés pour détecter une position d'interférence d'une unité d'approvisionnement de composants (30) et de la buse d'attraction (14-1, 14-2, 14-3; 121), lesdits moyens de détection de position d'interférence (24, 126) étant connectés à des moyens d'entrées/sorties (22, 132) de l'unité principale de commande (5, 130).
